# EUROPEAN PATENT SPECIFICATION

(11) **EP 1 797 155 B1**
(45) Date of publication and mention of the grant of the patent: **07.10.2015**
(21) Application number: 05786547.9
(22) Date of filing: 22.08.2005
(51) Int. Cl.: C09K 5/14, C08K 3/38, C09K 5/06, H01L 23/373

(54) **THERMALLY CONDUCTIVE COMPOSITION AND METHOD FOR PREPARING THE SAME**
THERMISCH LEITENDE ZUSAMMENSETZUNG UND HERSTELLUNGSVERFAHREN DAFÜR
COMPOSITION THERMOCONDUCTRICE ET SON PROCEDE DE PREPARATION

(30) Priority: 23.08.2004 US 603777; 14.03.2005 US 661395
(43) Date of publication of application: 20.06.2007
(73) Proprietor: GENERAL ELECTRIC COMPANY, Schenectady, NY 12345 (US)
(72) Inventor: ZHONG, Hong, Niskayuna, NY 12309 (US); PAISNER, Sara, Naomi, Albany, NY 12209 (US); GOWDA, Arun, Virupaksha, Niskayuna, NY 12309 (US); ESLER, David, Richard, Mayfield, NY 12117 (US); TONAPI, Sandeep, Shrikant, Chandler Arizona 85248 (US); DAVID, Jennifer, Ballston SPA, NY 12020 (US); MENEGHETTI, Paulo, Avon, OH 44011 (US); MANICCIA, Laurence, Lyndhurst, OH 44124 (US); HANS, Paul, Joseph, Medina, OH 44256 (US); FORTUNA, Robert, Parma, OH 44103 (US); STROSAKER, Gregory, A., Solon, OH 44139 (US); SHAFFER, Gregory W., Strongsville, OH 44136 (US); VICTOR, Hollister, Cleveland, OH 44111 (US)
(74) Representative: Zimmermann & Partner Patentanwälte mbB
(86) International application number: PCT/US2005/029808
(87) International publication number: WO 2006/023860

(56) References cited:
- EP-A- 0 322 165
- EP-A- 1 143 511
- EP-A- 1 414 063
- WO-A-03/027207
- US-A- 5 681 883
- US-A1- 2002 135 984
- US-A1- 2003 073 769
- US-A1- 2003 207 064
- US-A1- 2004 009 353
- US-B2- 6 713 088

## Description

### FIELD OF THE INVENTION

The present invention relates to a thermally conductive composition for use in electronic applications.

### BACKGROUND OF THE INVENTION

The removal of heat from electronic devices has become increasingly important, particularly in personal computers. With increasing processing speed and the trend of miniaturization, the heat flux of the microprocessor increases significantly. As the temperature of the microprocessor increases, the probability of personal computers malfunctioning also increases. It is imperative to remove the excess heat and keep the processor under certain temperatures. The increased heat removal requires sophisticated thermal management techniques to facilitate heat removal. One technique involves the use of some form of heat dissipating unit, e.g., heat spreader, heat sink, lid, heat pipe, etc., to conduct heat away from high temperature areas in an electrical system. A heat dissipating unit is a structure formed from a high thermal conductivity material, e.g., copper, aluminum, silicon carbide, metal alloys, polymer composites and ceramic composites, etc., that is mechanically coupled to a heat generating unit to aid in heat removal. The surface of the heat dissipating unit and the surface of the heat-generating component will rarely be perfectly planar or smooth, so air gaps exist between the surfaces. The air gaps reduce the effectiveness and value of the heat-dissipating unit as a thermal management device.

Polymeric compositions have been developed as an interface material for and between electronic components, i.e., a placement material in the air gaps. In one example, a thermally conductive composition is placed between the heat transfer surfaces as a thermal adhesive material. In another example, the composition is used as an underfill in flip chip assemblies (""FCs") and the like. In yet another example, the polymeric material serves to encapsulate devices in electronic module assembly. Another example of a thermally conductive composition is an admixture of cured polymer gel component and a filler component. In another example, the composition is in the form of a grease containing a thermoconductive filler because of its low thermal resistance. The grease itself exerts thermal conductivity. In another embodiment, the composition is in the form of a thermoconductive sheet comprising an organic resin and a filler such as boron nitride. The thermally conductive sheet may be in the form of a thermal pad, a phase change film, a thermal tape, etc.

Desirable properties of the polymeric compositions for the interface applications above include low thermal resistivity, stable thermal resistance, and for adhesives, high adhesion strength with various contacting materials, maintaining bond integrity during reliability stress exposures involving thermal cycling, thermal shock, high temperature storage test and high temperature/high humidity storage test, void-free bond line, thermal stability of up to 200°C, paste viscosity suitable for dispensing, screen printing, stencil printing or any other application methods known to those skilled in the art, and polymer-conductive filler dispersion stability with little change in viscosity for an extended period of time. In Patent Publication EP 0322165 A1 a thermally conductive composition is disclosed wherein boron nitride of median particle size of between about 130 to 260 microns is used as a filler in a range of 20 to 60 volume %.

In another reference, WO 2003/027207 A1, it is disclosed that by incorporating substantially spherical boron nitride as a thermally conductive filler, a phase change film can have higher thermal conductivity in the thickness direction than that in the case of using plate-like boron nitride particles as well as reduced initial thermal resistance before the phase-change. The "spherical" boron nitride particles used, e.g., PT620 and PT670, are defined to have an aspect ratio in the range of 1 to 5. These are in fact irregularly shaped particles and not spherical at all. As used in the art, the "aspect ratio" is defined as the ratio of major diameter to minor diameter of a particle, that is an index indicating whether the particle shape is approximate to sphere. An aspect ratio of more than 2 indicates that particles have a shape dissimilar from sphere, leading to disturbed flow. The lower limit of the aspect ratio is, though not critical, preferably close to 1.

US Patent No. 6,713,088 B2 discloses spherical boron nitride powder comprising spherical agglomerates of boron nitride platelets, wherein the spherical boron nitride agglomerates are bound together by an organic binder and then spray dried for the agglomerates or particles to have an average diameter greater than about 1 micron. US Patent No. 6,652,822 B2 discloses "solid" spherical boron nitride particles, wherein the solidly spherical boron nitride particles are generated by melting precursor particles of boron nitride suspended in an aerosol gas by plasma, and forming solid spherical boron nitride product particles upon cooling and solidifying.

US 2003/073769 A1 discloses a method for making a hexagonal boron nitride slurry and a polymer blend comprising: a polymer and a powder phase comprising spherical agglomerates of hexagonal boron nitride platelets, wherein the powder phase is distributed homogeneously within the polymer. In more detail, this document is concerned with a polymer blend including a polymer and a powder phase which includes spherical agglomerates of hexagonal boron nitride platelets which result from a spray drying process of the above mentioned slurry. The powder phase is homogeneously distributed within the polymer which is selected from the group consisting of melt-processable polymers, polyesters, phenolics, silicone polymers (e.g., silicone rubbers), acrylics, waxes, thermoplastic polymers, low molecular weight fluids, and epoxy molding compounds.

EP 1 414 063 A2 relates to thermal interface pads which employ a combination of a liquid metal with a polymer carrier. The liquid metal may either be employed as a filler by itself or preferably as a coating or encapsulant for other fillers dispersed in the polymer carrier. The filler or the filler combinations may be pretreated with octyl-triethoxysilane, or other such hydrophobic surfactants, to aid in binding the surface oxide layer of the liquid metal component. Alternatively, the silane component is blended in the polymeric matrix. The polymeric matrix is preferably selected from the group of compliant compositions including inter alia silicone waxes and elastomers such as silicone, natural or synthetic rubber, acrylic, polyurethane. According to the teaching of this document, the polymeric matrix is selected, and blended with a quantity of a liquid metal.

EP 1 143 511 A2 refers to a method and a composition for preparing thermally conductive mechanically compliant compounds for improving heat transfer from a heat generating semiconductor device to a heat dissipator such as a heat sink or heat spreader. More specifically, this document relates to the preparation of improved formulations of highly thermally conductive polymer compounds such as a polymer liquid loaded or filled with percolating particulate clusters coated with a liquid metal. In accordance with the teaching of this document, a particulate such as boron nitride is placed in contact with a liquid metal, i.e. for example a metal that is liquid at room temperature or which melts at a relatively low temperature. Such a liquid metal comprises an alloy of gallium and/or indium, such as a gallium-indium-tin-zinc alloy, a bismuth-indium alloy or a tin-indium-bismuth. Following the coating operation, the coated particulate is mixed with a blend of a liquid polymeric carrier material such as, for example, liquid silicone oil of a desired or selected viscosity with octyl-triethoxysilane.

The invention provides a novel thermally conductive composition comprising a blend of a polymer matrix and spherical boron nitride agglomerates as a filler, for use as a thermal interface material in the form of a grease, an adhesive, a gel, a phase change material, a pad, a tape, a foil, etc. in electronic applications.

### SUMMARY OF THE INVENTION

The invention relates to a thermally conductive composition comprising a blend of a polymer matrix and spherical boron nitride agglomerates as a filler, wherein the spherical boron nitride agglomerates are formed of irregular non-spherical BN particles bound together by a binder and subsequently spray-dried, and having an average aspect ratio of less than 2 and wherein the agglomerates are coated with at least one of a metal powder, a metal alloy powder, a fatty acid partial ester of sorbitan anhydride, a titanate, a zirconate, a benzoic acid derivative, an acytoxy silane, an alkoxy silane, a methoxy silane, a sorbitan monostearate, a sorbitan monolaurate, a sorbitan monoleate, a sorbitan monopalmate, a polyoxyethylene sorbitan monolaurate, a polyoxyethylene sorbitan monostearate, a polyoxyethylene sorbitan monooleate, a polyoxyethylene sorbitan monopalmate, a silazane, a silanol, a silane compound, a siloxane compound, a polymer containing alkoxy, hydroxy or Si-H group, a titanate, a zirconate, a benzoic acid derivative, and mixtures thereof.

In one aspect of the invention, there is provided a thermally conductive composition comprising a blend of a polymer matrix and spherical boron nitride agglomerates having an average aspect ratio of less than 2 as a filler, wherein the polymer matrix is selected from a polyolefin, a polyol-ester, an organo-siloxane, a curable material selected from the group consisting of polydimethylsiloxanes, epoxies, acrylates, organopolysiloxane, polyimide, fluorocarbons, benzocyclobutene, fluorinated polyallyl ether, polyamide, polyimidoamide, cyanate esters, phenolic resin, aromatic polyester, poly arylene ether, bismaleimide, fluororesins, and combinations thereof.

### DETAILED DESCRIPTION OF THE INVENTION

The thermally conductive composition of the invention may be used in thermal management applications in various forms, including phase change materials ("PCM") in the form of a free-standing film or with a carrier, a thermal pad or sheet, a grease, a gel, a flux, an adhesive, or a tape. PCMs are materials which are self-supporting and form-stable at room temperature, i.e., about 25° C., in a solid, semisolid, glassy, or crystalline first phase or state for ease of handling, but is substantially conformable at an elevated temperature. For example, at the operating temperatures of the electronic components, the PCMs will soften or liquify as to form a viscous but flowable phase that conforms to the interface surfaces.

The composition of the invention comprises spherical boron nitride agglomerate fillers in a matrix of interface material. In one embodiment, the composition comprises optional components such as dispersing agents, other type of fillers, etc.

Spherical Boron Nitride Filler Component A: As used herein, "spherical boron nitride" refers to generally solid agglomerated particles of a spherical geometry, formed of irregular non-spherical BN particles bound together by a binder and subsequently spray-dried. In one embodiment, the spherical boron nitride is optionally heat treated to 1800 to 2100°C.

Examples of binders include water-soluble acrylics, acetates, polycarboxylic acids, silanes, etc. Spherical boron nitride powder is commercially available from GE Advanced Ceramics of Strongsville, Ohio. A description of the spherical boron nitride filler for use with the thermally conductive composition of the invention may be found in US Patent No. 6,713,088 B2.

In one embodiment, the binder is an inorganic binder selected from the group consisting of oxides of boron (e.g., boric oxide), aluminimum, silicone, rare earth and alkaline earth metallic elements and / or residues of an organic binder i.e., decomposition product thereof. In another embodiment, the binder is an organic binder selected from the group consisting of but not limited to acrylics, C₁ - C₄ alkyl esters of acrylic or methacrylic acids such as methyl acrylate, ethyl acrylate, butyl acrylate, methyl methacrylate, ethyl methacrylate, butyl methacrylate and isobutyl methacrylate; hydroxylalkyl esters of acrylic or methacrylic acids such as hydroxyethyl acrylate, hydroxypropyl acrylate, hydroxyethyl methacrylate and hydroxypropyl methacrylate; acrylamides and alkyl-substituted acrylamides including acrylamide, methacrylamide, N-tertiarybutylacrylamide, N-methacrylamide and N,N-dimethacrylamide, dimethylaminoethyl acrylate, dimethylaminoethyl methacrylate; acrylonitrile, methacrylonitrile, and polyvinyl alcohol.

In one embodiment, the ratio of the particles of BN have a surface layer composed of a binder or decomposition product thereof in a molar ratio of binder to boron nitride of between about 0.00170-0.008.

In one embodiment, the spray-dried spherical boron-nitride agglomerates as prepared in US Patent No. 6,713,088 B2 may be reduced to a desirable size range by using any combination of jaw crushing, roll crushing and/or fine milling processes. Coarse agglomerates that are greater than the target particle size may be re-crushed and classified until they are within the target size distribution. In one embodiment, the spray-dried spherical boron-nitride agglomerates may undergo cold pressing or isostatic pressing to form a new log, briquette, or pellet with desirable crystalline properties. Following pressing, the new log, briquette, or pellet is crushed again. The pressing and crushing steps may be repeated any number of times to modify the crystal size, particle size, particle size distribution of the resulting spherical BN feedstock powder for use in the thermally conductive composition of the invention.

In yet another embodiment, the spray-dried spherical boron-nitride agglomerates as prepared in US Patent No. 6,713,088 B2 may be sintered prior to being used in the thermally conductive composition of the invention. The sintering operation facilitates crystal growth and crystallization of the amorphous phases, so as to cause a reduction in density of the final BN product, i.e., as suggested in "Sintering of the Mechanochemically Activated Powders of Hexagonal Boron Nitride," Communications of the American Ceramic Society, Vol. 72, No. 8, pps. 1482-1484 (1989) by Hagio et al.

In yet another embodiment, the spray-dried spherical boron-nitride agglomerates may be used as received or may be surface-treated prior to being used in the thermally conductive composition of the invention. The surface treatment may compatibilize BN particle surface with the matrix polymer, and may thus lower the viscosity of BN-filled materials.

Filler treatments include, but are not limited to, ball-milling, jet-milling, chemical or physical coating or capping via procedures such as treating fillers with chemicals such as silazanes, silanols, silane or siloxane compounds, polymers containing alkoxy, hydroxy or Si-H groups, or other commonly used filler-treatment reagents in the prior art, using procedures commonly adopted by those skilled in the art, including those disclosed in EP0424094A1 and US Patent No. 5,681,883 A.

In one embodiment, the spherical boron nitride agglomerates are treated with a titanate and / or zirconate coupling agent such as isopropyl triisosteroytitanate. In a second embodiment, the spherical boron nitride agglomerates are surface treated with a benzoic acid derivative, e.g., ester, amide, acid anhydride and acid chloride. In one embodiment, the agglomerates are treated with a para-functionalized benzoic acid.

In yet another embodiment, the spherical boron nitride agglomerates are treated with at least one of an acyloxy-, alkoxy-, methoxy silane, or combinations thereof. In one embodiment, the spherical boron nitrides are treated with an alkoxy silane. In another embodiment, the alkoxy silane is a methoxy silane selected from the group of methyl-trimethoxy silane, vinyl trimethoxyl silane, organosilane ester tris[3-trimethoxysilyl)propyl] isocyanurate, bis[trimethoxysilyl)propyl] amine and gamma-ureidopropyl trimethoxy silane.

In one embodiment, the spray-dried spherical BN agglomerates may be coated with a coating layer of up to 10 wt.% of the final spherical boron agglomerates. In one embodiment, the coating layer is in an amount of 0.5 to 5 wt.% of the spherical boron agglomerates. One example of a coating agent is an organic surfactant having hydrophobic groups and terminates in acid functional groups. Another example of a coating agent is a mixture of at least two surfactants, one having hydrophilic groups and the other having hydrophobic groups. In another embodiment, the coating or surfactant is a combination of a sorbitan diester and sorbitan monoester. In one example, the coating layer is the monoester of sorbitan anhydride, e.g., sorbitan monostearate, sorbitan monolaurate, sorbitan monoleate, and sorbitan monopalmate. In one embodiment, the coating material comprises a metal powder, e.g., copper or its alloy, having a thickness of 1-100 microns, in a process as disclosed in JP 59-13336 A.

In one embodiment of the invention, the boron nitride agglomerates have a substantially spherical shape with average aspect ratios ranging from 1 to about 2. In a second embodiment, the average aspect ratio of the agglomerates ranges from 1 to about 1.5. In a third embodiment, the average aspect ratio ranges from 1 to about 1.3. In a fourth embodiment, the average aspect ratio ranges from 1 to about 1.25. In a fifth embodiment, the average aspect ratio is less than about 1.1.

In one embodiment, the spray-dried spherical boron-nitride agglomerates have a generally spherical shape with a diameter (of the spherical agglomerate) of about 1 micron to about 150 microns. In another embodiment, the spherical boron-nitride agglomerates have an average diameter of about 20 to 100 microns. In a third embodiment, the spherical boron nitride agglomerate have an average diameter of about 30 to 70 microns. In a fourth embodiment, the spherical boron nitride agglomerates have an average diameter of about 70 to 100 microns.

In one embodiment of the invention, the spray-dried spherical boron nitride powder in the form of agglomerates has a tap density of about 0.3g/cc to 0.7 g/cc. In another embodiment, the spherical boron nitride powder has a tap density of about 0.4 g/cc to 0.7 g/cc. In a third embodiment, the spherical boron nitride powder has a tap density of about 0.2 g/cc to 0.6 g/cc.

In yet another embodiment of the composition of the invention, the filler used is a spray-dried spherical boron nitride powder having a fracture strength to envelope density ratio not less than 6.5 MPa.cc/g. The strength of the agglomerates is evaluated using compression testing of the agglomerates and quantifying the strength distribution, i.e., measuring the median load that the agglomerates can withstand with 50 % survival probability. The force required to crush a particle may be measured with a Shimpo Force Gage designated FGE-50 obtained from Shimpo Instruments in Itasca, EL, or similar instruments.

In one embodiment, the spherical boron nitride agglomerate filler is used in an amount sufficient for the desired electrical conductivity and EMI shielding effect for the intended application. In most applications, this EMI shielding effectiveness is of at least 10 dB over a frequency of about 10 MHz to 10 GHz.

In another embodiment, the spherical boron nitride agglomerate filler is used in an amount sufficient to provide the thermally conductive composition with a thermal conductivity of at least about 0.5 W/m K and a thermal impedance, measured per ASTM 5470, of less than about 6.45 °C·cm²/W (1 °C· in²/W), without impacting other desirable properties of the thermally conductive composition.

In yet another embodiment, the amount is sufficient for the thermally conductive composition to have a viscosity of less than about 15 million cps at about 25-30 °C. In another embodiment, the amount of spherical boron nitride and other fillers such as silver and the like is sufficient for the thermally conductive composition to have an electrical volume resistivity of not greater than about 1 ohm-cm.

In one embodiment, the spherical boron nitride is used in an amount of 5 to 95 wt. % as filler in the composition. In another embodiment, the spherical boron nitride is present in an amount of 15 to about 90 wt. %. In a third embodiment, in the range of about 35 to 85 wt. %. In a fourth embodiment, in an amount of 10 to 45 wt. %.

"Matrix" or "Interface" Material Component B The spherical boron nitride agglomerates and optional components such as fillers, dispersing agents, etc., are incorporated into a matrix material. This matrix component functions as the base for the thermally conductive composition. As used herein, the term "matrix" may be used interchangeably with the term "interface."

In one embodiment, the base matrix is a polymeric material. Suitable matrix materials include, but are not limited to, polydimethylsiloxane resins, epoxy resins, acrylate resins, other organo-functionalized polysiloxane resins, polyimide resins, fluorocarbon resins, benzocyclobutene resins, fluorinated polyallyl ethers, polyamide resins, polyimidoamide resins, phenol cresol resins, aromatic polyester resins, polyphenylene ether (PPE) resins, bismaleimide resins, fluororesins, mixtures thereof and any other polymeric systems known to those skilled in the art. (For common polymers, see "Polymer Handbook:, Branduf, J.,; Immergut, E.H; Grulke, Eric A; Wiley Interscience Publication, New York, 4th ed.(1999); "Polymer Data Handbook Mark, James Oxford University Press, New York (1999)). Resins may also include hardenable thermoplastics.

In one embodiment, the matrix component comprises a silicone composition having stable thermoconductive properties over a long period of time, i.e., one which does not exude oil over time such that the heat-dissipating properties decline. An example is an organopolysiloxane having a thixotropicity degree of 1.03 to 1.5 and a viscosity at 25°C of 100 - 1,000,000 mm²/s. In one embodiment, the organopolysiloxane is a polydimethylsiloxane, a polyalkylsiloxane, a polydimethyl-co-methylphenyl-siloxane, a polydimethyl-co-diphenyl-siloxane or a functionalized organopolysiloxane fluid. In another embodiment, the organopolysiloxane is obtained by an addition reaction between an organopolysiloxane having two or more alkenyl groups in the molecule, and a hydrogen organopolysiloxane having two or more SiH groups, in the presence of a platinum catalyst.

In one embodiment, the matrix component comprises a silicone resin mixture including a vinyl terminated siloxane, a crosslinker and a catalyst. The interface material is characterized as being compliant and crosslinkable. As used herein, the term "compliant" encompasses the property of a material that is yielding and formable at room temperature, as opposed to solid and unyielding at room temperature. As used herein, the term "crosslinkable" refers to those materials or compounds that are not yet crosslinked.

Examples of silicone resin mixtures include mixtures of vinyl silicone, vinyl Q resin, hydride functional siloxane and platinum-vinylsiloxane. The resin mixture can be cured at either at room temperature or elevated temperature to form a compliant elastomer. The reaction is via hydrosilylation (addition cure) of vinyl functional siloxanes with hydride functional siloxanes in the presence of a catalyst, such as platinum complexes, rhodium complexes, or nickel complexes.

In one embodiment, the base matrix comprises a thermoset resin, or a curable material. This includes but is not limited to a silicone resin, epoxy resin, acryloxy resin, or any combination thereof. In one embodiment, the matrix component is a dispensable formulation at mixing that hardens to an immobilized solid upon curing. The final properties of thermal conductivity and electrical insulation are obtained on curing.

In one embodiment, the curable matrices include acrylate resins, epoxy resins, polydimethyl siloxane resins, other organo-functionalized polysiloxane resins that can form cross-linking networks via free radical polymerization, atom transfer radical polymerization, nitroxide mediated radical polymerization, reversible addition-fragmentation transfer polymerization, ring-opening polymerization, ring-opening metathesis polymerization, anionic polymerization, cationic polymerization or any other method known to those skilled in the art, and mixtures thereof. Suitable curable silicone resins include, for example, the addition curable and condensation curable matrices as described in "Chemistry and Technology of Silicone", Noll, W.; Academic Press 1968.

The curing process can be performed by any process known to those skilled in the art. Curing can be done by methods such as thermal cure, UV light cure, microwave cure, e-beam cure, free radical cure initiated with free radical initators and combinations thereof. Typical free radical initiators may include, but are not limited to, organic peroxides (*e.g.,* benzoyl peroxide), inorganic peroxides (*e.g.,* hydrogen peroxide), organic or inorganic azo compounds (e.g., 2-2'-azo-bis-isobutyrylnitrile), nitroxides (e.g. TEMPO) or combinations thereof.

Curing of the matrix material typically occurs at a temperature in a range between about 20°C and about 250°C, more typically in a range of about 50°C and about 150°C. In one embodiment, the resins are chosen such that the curing temperature is about 10°C to about 200°C. Curing typically occurs at a pressure in a range between about 101,33 kPa (1 atmosphere (atm)) and about 34473,79 kPa (5000 pounds pressure per square inch), more typically in a range between about 101,33 kPa, (1 atm) and about 689,48 kPa (100 pounds per square inch (psi)). In addition, curing may typically occur over a period in a range between about 30 seconds and about 5 hours, and more typically in a range between about 90 seconds and about 120 minutes. Optionally, the cured composition can be post-cured at a temperature in a range between 120°C - 150°C over a period of about 1 hour to about 4 hours.

In one embodiment, the matrix component comprises a common epoxy resin, such as a multifunctional epoxy resin. Ordinarily, the multifunctional epoxy resin should be included in an amount within the range of about 15 to about 75 weight percent, such as about 40 to about 60 weight percent, based on the weight of the total of the epoxy resin component. In the case of bisphenol-F-type epoxy resin, desirably the amount thereof should be in the range of from about 35 to about 65 weight percent, such as about 40 to about 50 weight percent of the total of the epoxy resin component. Appropriate acidic fluxing agents for use herein include abietic acid, adipic acid, ascorbic acid, acrylic acid, citric acid, 2-furanoic acid, malic acid, salicylic acid, glutaric acid, pimelic acid, polyacrylic acids, and organic acids, such as phenol and derivatives thereof, and sulfonic acids, such as toluene sulfonic acids. Appropriate anhydride compounds for use herein include mono- and poly-anhydrides, such as hexahydrophthalic anhydride, methyl hexahydrophthalic anhydride, nadic methyl anhydride, 3,3',4,4'-benzophenone tetracarboxylic dianhydride ("BTDA"), pyromellitic dianhydride, etc. The latent curing agent component is selected from materials capable of catalyzing the polymerization of the epoxy resin component once a triggering event occurs, such as a certain temperature is reached.

Where epoxy resins are utilized as the base material for the interface material, hardeners such as carboxylic acid-anhydride curing agents and an organic compound containing hydroxyl moiety can be added as optional reagents with the curing catalyst. Where epoxy resins are used, curing catalysts may be selected from, but are not limited to, amines, alkyl-substituted imidazole, imidazolium salts, phosphines, metal salts, triphenyl phosphine, alkyl-imidazole, and aluminum acetyl acetonate, iodonium compounds and combinations thereof. For epoxy resins, curing agents such as multi-function amines can be optionally incorporated as cross-linking agents. Exemplary amines may include, but are not limited to ethylene diamine, propylene diamine, 1,2-phenylenediamine, 1,3-phenylene diamine, 1,4-phenylene diamine; and any other compounds containing 2 or more amino groups.

The thermally conductive compositions of the present invention may be of the one-part type, in which all the ingredients are mixed together, or of the two-part type. In one embodiment, the matrix component comprises a B-stage curable composition.

In one embodiment, a B-stage curable composition may include a first component that is heat curable at a first temperature; a second component, which is either heat curable at a second temperature that is higher than the first temperature or curable upon exposure to radiation in the electromagnetic spectrum; and a heat cure catalyst for the solid curable component. The heat cure catalyst is used to reduce the temperature at which cure occurs or hasten the degree of cure when the appropriate temperature condition is selected for cure to occur. In a second embodiment, a B-stage curable composition is one that may be hardened into a solid mass at a first temperature, and may then be completely cured at a second and higher temperature or upon exposure to irradiation in the electromagnetic spectrum.

As the solid heat curable component, epoxies, episulfides, maleimides, itaconimides and nadimides may be used. The epoxy resin in the solid state may include the monofunctional epoxy compounds. In one embodiment for an underfill application, the matrix component is an epoxy based compound to lower moisture pick up, and better match the coefficient of thermal expansion ("CTE") of the substrates. Examples of epoxy resins include polyglycidyl derivatives of phenolic compounds, such as those available from Resolution Performance, under the EPON tradename, such as EPON 1009F. Polyglycidyl adducts of amines, aminoalcohols and polycarboxylic acids are also useful as the solid curable component. As the liquid curable component, epoxies, episulfides, maleimides, nadimides, itaconimides, (meth)acrylates, maleates, fumarates, vinyl ethers, vinyl esters, allyl amides, styrene and derivatives thereof, poly(alkenylene)s, norbornenyls, thiolenes and the like may be used. The heat cure catalyst may be chosen from free radical catalysts, anionic curatives, cationic curatives, and combinations thereof.

In applications to attach one substrate, such as a chip die, to another substrate, such as a circuit board or a another chip die, the B-stage curable composition is first applied to at least one of the substrate surfaces, and is then exposed to conditions favorable to lightly cross-link the composition, thereby forming a B-staged curable film. The substrate with B-staged curable film may be stored till ready for attaching to a second substrate. The B-staged curable film is then exposed to a temperature condition sufficient to melt the solid film, and may then be cured to completeness at this temperature, thereby joining the two substrate surfaces together to form a 3-layered structure in which the B-stage curable composition is interposed between the two substrate surfaces.

Curing Catalysts: For matrix components comprising a curable material, the matrix component may also further contain at least one catalyst. The catalyst is selected from any group of catalysts compatible with the curable resin utilized in the matrix component. Where epoxy resins are utilized, hardeners such as carboxylic acid-anhydride curing agents and an organic compound containing hydroxyl moiety can be added as optional reagents with the curing catalyst. For epoxy resins, exemplary anhydride curing agents typically include methylhexahydrophthalic anhydride, 1,2-cyclohexanedicarboxylic anhydride, bicyclo[2.2.1]hept-5-ene-2,3-dicarboxylic anhydride, methylbicyclo [2.2.1]hept-5-ene 2,3-dicarboxylic anhydride, phthalic anhydride, pyromellitic dianhydride, hexahydrophthalic anhydride, dodecenylsuccinic anhydride, dichloromaleic anhydride, chlorendic anhydride, tetrachlorophthalic anhydride, and the like. Combinations comprising at least two anhydride curing agents may also be used. Illustrative examples are described in "Chemistry and Technology of the Epoxy Resins" B. Ellis (Ed.) Chapman Hall, New York, 1993 and in "Epoxy Resins Chemistry and Technology", edited by C. A. May, Marcel Dekker, New York, 2nd edition, 1988. Additional catalysts include amines, alkyl-substituted imidazole, imidazolium salts, phosphines, metal salts, triphenyl phosphine, alkyl-imidazole, and aluminum acetyl acetonate, iodonium compounds, onium salts and combinations thereof. For epoxy resins, curing agents such as multi-functional amines or alcohols can be optionally incorporated as cross-linking agents. Exemplary amines may include, but are not limited to ethylene diamine, propylene diamine, 1,2-phenylene diamine, 1,3-phenylene diamine, 1,4-phenylene diamine, and any other compounds containing 2 or more amino groups. Exemplary alcohols may include, but are not limited to, phenolic resins, Novolak systems, bisphenols, and any other compounds containing two or more hydroxyl groups, or others known to one of ordinary skill in the art.

Where acrylates are used, curing catalysts can be selected from, but are not limited to, cationic curing initiators such as iodonium compounds or onium salts, or radical cuing initiators such as peroxides or azo-compounds, or others known to one of ordinary skill in the art. Where condensation-cure siloxane resins are used, an optional Lewis-acidic catalyst such as an organometallic tin compound (e.g. Sn (acetate)2) can be used. Additionally, for addition curable silicone resins as base matrix material, catalysts include compounds containing Group 8-10 transition metals (i.e. ruthenium, rhodium, platinum, palladium) complexes. Preferably the catalyst for an addition curable silicone resin is a platinum complex. Preferred platinum complexes include, but are not limited to, fine platinum powder, metal black, metal adsorbed on solid supports such as alumina, silica or activated carbon, choroplatinic acid, metal tetrachloride, metal compounds complexed with olefins or alkenyl siloxanes such as divinyltetramethyldisiloxanes and tetramethyl-tetravinylcyclotetrasiloxane, and combinations thereof.

Catalyst inhibitors can be added to modify the curing profile of addition curable silicone resins and to achieve desired shelf life for the composition. Suitable inhibitors include, but are not limited to, phosphine or phosphite compounds, sulfur compounds, amine compounds, isocyanurates, alkynyl alcohol, maleate and fumarate esters, and mixtures thereof, and other compounds known to those skilled in the art. Some representative examples of suitable inhibitors also include triallylisocyanurate, 2-methyl-3-butyn-2-ol, triphenylphosphine, tris(2,4-di-(tert)-butylphenyl)phosphite, diallyl maleate, diethyl sulfide and mixtures thereof.

Matrix Component Comprising an Organic-Inorganic hybrid. In another embodiment, the polymeric matrix can be an organic-inorganic hybrid matrix. Hybrid matrices include any polymers that contain chemically bound main group metal elements (e.g., aluminum, magnesium, gallium, indium), main group semi-metal elements (e.g. boron, germanium, arsenic, antimony), phosphorous, selenium, transition metal elements (e.g., platinum, palladium, gold, silver, copper, zinc, zirconium, titanium, ruthenium, lanthanum, etc.) or inorganic clusters (which include, but are not limited to, polyhedral oligomeric silsesquioxanes, nano metal oxides, nano silicon oxides, nano metal particles coated with metal oxides, and nano metal particles.) Organic-inorganic hybrid polymeric matrices may refer to, but are not limited to, copolymerization products between organic monomers, oligomers or polymers that contain polymerizable groups such as alkenyl, allyl, Si-H, acrylate, methacrylate, styrenic, isocyanate, epoxide and other common groups known to those skilled in the art, and inorganic clusters or organometallic compounds containing polymerizable groups. Organic-inorganic hybrid matrices also include cases where the inorganic cluster or organometallic compound has no polymerizable functional groups, but can become part of the polymer network through its surface OH or other functional groups.

As used herein, "chemically bound" refers to bonding through a covalent bond, an ionic interaction, an iono-covalent bond, a dative bond or a hydrogen bond. Organic-inorganic hybrid polymeric matrices may refer to, but are not limited to, copolymerization products between organic monomers, oligomers or polymers that contain polymerizable groups such as alkenyl, allyl, Si-H, acrylate, methacrylate, styrenic, isocyanate, epoxide and other common groups known to those skilled in the art, and inorganic clusters or organometallic compounds containing polymerizable groups. For example, the copolymerization product between an acrylate or a methacrylate and a metal acrylate or methacrylate compound is an organic-inorganic hybrid polymeric matrix. The copolymerization product between an epoxide and an epoxide-functionalized inorganic cluster is also considered an inorganic-organic hybrid polymer. The homo-polymerization products of organo-functionalized inorganic clusters or organometallic compounds, or the copolymerization products among different organo-functionalized inorganic clusters or organometallic compounds, are also considered organic-inorganic hybrid matrices. Organic-inorganic hybrid matrices also include cases where the inorganic cluster or organometallic compound has no polymerizable functional groups, but can become part of the polymer network through its surface OH or other functional groups.

Matrix Component Comprising a Wax-based Compound: In one embodiment, the base material of the thermally conductive composition is a wax having a melting point from 30 to 150°C. Any type of wax can be used in this thermally conductive composition, including natural wax, synthetic wax or blended wax. Examples of the natural wax include plant waxes such as candelilla wax, carnauba wax, rice wax, haze wax and jojoba oil; animal waxes such as beeswax, lanolin and spermaceti; mineral waxes such as montan wax, ozokerite and ceresin; and petroleum waxes such as paraffin wax, microcrystalline wax and petrolactam. Examples of the synthetic wax include synthetic hydrocarbons; denatured waxes, paraffin wax derivatives and microcrystalline wax derivatives; hydrogenated waxes; fatty acids, acid amides, esters, ketones, and other waxes such as 12-hydroxystearic acid, stearic acid amide, anhydrous phthalic imide and chlorinated hydrocarbon. In one embodiment, an optional softening agent may be added. Examples include a plant-type softening agent, a mineral-type softening agent and mixtures thereof.

The wax-based composition can be produced by mixing these components each in a predetermined amount, then formed into a sheet or a film by the method commonly known in this field. For example, wax, spherical boron nitride, optional softening agents and the like are kneaded in a heat mixer and the kneaded material is coated like a liner by the hot-melt coating, and thereby formed into a sheet. Or, the above-described components are diluted with an appropriate solvent and mixed in a mixer and the mixture is coated on a liner by the solvent casting method and thereby formed into a sheet. The sheet can be formed to various thicknesses according to the end use application. However, in general, the thickness, may be as thin as possible, e.g. from 0.02 to 2.0 mm, and in another embodiment, from 0.1 to 0.5 mm. Matrix Component Comprising a Non Silicone / Non-Wax based material. In one embodiment, the matrix component comprises a polyolefin based composition which is capable of changing reversibly from a solid into a paste or liquid at an elevated temperature. In one embodiment, the polyolefin polymer is selected from the group of an α-olefin based polymer, an ethylene / α-olefin copolymer, and an ethylene / α-olefin / non-conjugated polyene random copolymer. In one embodiment, the composition is used as a heat-softening heat-radiation sheet having a viscosity at 80°C of 10² to 10⁵ Pas-·s and a plasticity at 25°C in the range from 100 to 700.

In another embodiment, the matrix component comprises a non-silicone, non-wax-based material which can be dried quickly due to the evaporation of solvents in the composition. An example is a polyol-ester, such as HATCOL 2373, the spherical boron nitride filler, optionally an oil such as polyisobutene for use as a viscosity index improver, an optional solvent, and optional surfactant(s). Examples of solvents include naphtha, hexane, heptane, and other quick-dissipating petroleum distillates. Depending on whether the thermally conductive compound is to be used as thermal grease or a dense thermal paste, surfactants may or may not be needed. An exemplary surfactant is polyglycolether. The surfactant facilitates the formation of the grease compound into a thin film.

In one embodiment, the non-silicone / non-wax compound can also be combined with, e.g., a propellant and applied by spraying directly onto the electronic component or substrate in the desired thickness, as would be known in the art. The compound can also be screen printed directly onto the electronic component or substrate.

Matrix Component Comprising a Viscoelastic Composition. In one embodiment, the matrix component comprises a viscoelastic material that melts at a temperature within the range of the operating temperature of the heat source. Particularly, the interface material undergoes a viscoelastic change at microprocessor operating temperatures to transfer heat generated by a heat source to a heat sink. In one embodiment, the viscoelastic composition comprises (1) a thermoplastic elastomer, (2) an oil compatible with the elastomer, and (3) a tackifying resin. The thermoplastic elastomer (1) is a styrene-alkylene block copolymer. The compatible hydrocarbon oil (2) comprises a mineral oil, a polyalphaolefin, or mixtures thereof. By the term "compatible" it is meant that the hydrocarbon oil is miscible, i.e., soluble in both the thermoplastic elastomer (1) and the tackifying resin (3). The tackifying (tackifier) resins (3), are known to those skilled in the art and have for example been described in detail in the Handbook of Pressure Sensitive Adhesive Technology, 2nd edition, 1989, edited by Donatas Satas, pages 527 to 544. Examples of tackifying (tackifier) resins include natural and modified rosin; glycerol and pentaerythritol esters of natural and modified rosins; and polyterpene resins having a softening point, as determined by ASTM method E28-58T, of from about 60 °C to 140 °C; copolymers and terpolymers of natural terpenes; phenolic-modified terpene resins; aliphatic petroleum hydrocarbon resins; and the like.

The spherical boron nitride filler materials (and other optional fillers) are mixed with a dispersing agent (B) and then into the viscoelastic composition. Dispersing agent (B) is selected from the group of metal alkyl sulfates, silanes, titanates, zirconates or aluminates, and mixtures thereof.

Optional Component C. Other materials may be added to the thermally conductive compound of the invention such as an adhesion promoter. An adhesion promoter may not only facilitate improved chemical interaction between precursors within the composition such as an increased compatibility among boron nitride and resin or other additives, but also improve the composition's adhesion to the substrate.

The adhesion promoters are present in an amount of from about 0 weight percent and about 5 weight percent, preferably, from about 0.01 weight percent and about 5 weight percent, more preferably about 0.01 to about 2 weight percent of the total final formulation, or any range or combination of ranges therebetween.

Adhesion promoters include epoxy silane and silanol terminated organosiloxane as adhesion promoting additives. Adhesion promoters may also include, but not limited to, any type of alkoxysilane compounds and siloxane fluids containing alkoxy moieties. Additionally, organo-titanate as a wetting enhancer may be added to reduce paste viscosity and to increase filler loading.

Other examples of adhesion promoters include alkoxy- or aryloxysilanes such as γ-aminopropyltrimethoxysilane, 3-glycidoxypropyltrimethoxysilane and bis(trimethoxysilylpropyl)fumarate, or alkoxy- or aryloxysiloxanes such as tetracyclosiloxanes modified with acryloxytrimethoxysilyl or methacryloxypropyltrimethoxysilyl functional groups. In one embodiment, the adhesion promoter is a cyclotetrasiloxanepropanoic acid, alpha 2,4,6,6,8-hexamethyl-3-(trimethoxysilyl)proply ester from GE Toshiba Silicones of Japan. They may also include, but are not limited to, silanols, oligosiloxanes containing one or more alkoxy silyl functional groups, oligosiloxanes containing one or more aryloxysilyl functional groups, polysiloxanes containing an alkoxy silyl functional group, oligosiloxanes containing containing one or more hydroxyl functional groups, polysiloxanes containing containing one or more aryloxysilyl functional groups, polysiloxanes containing containing one or more hydroxyl functional groups, cyclosiloxanes containing containing one or more alkoxy silyl functional groups, cyclosiloxanes containing containing one or more aryloxysilyl functional groups, cyclosiloxanes containing containing one or more hydroxyl functional groups, titanates, trialkoxy aluminum, tetraalkoxysilanes, isocyanurates, and mixtures, and combinations thereof.

In one embodiment wherein the composition is used as a phase change material (PCM), the PCM composition further comprises a melting point component which modifies the temperature at which the PCM softens or melts so that the PCM becomes flowable around the operating temperature of the microprocessor or the electronic component.

In one embodiment, dispersing agents are used to facilitate the dispersion of the spherical boron nitride filler in the thermally conductive compound to decrease the viscosity of the composition. Examples of dispersing agents include functional organometallic coupling agents or wetting agents, such as organosilane, organotitanate, organozirconium, metal alkyl sulfates, silanes, titanates, zirconates or aluminates, etc. In one embodiment, the dispersing agent is selected from reactive diluents such as 3-ethyl-3-hydroxymethyl-oxetane, dodecylglycidyl ether, 4-vinyl-1-cyclohexane diepoxide, di(β-(3,4-epoxycyclohexyl)ethyl)-tetramethyldisiloxane, and combinations thereof. In another embodiment, the dispersing agent is selected from unreactive diluents such as low boiling aliphatic hydrocarbons (e.g., octane), toluene, ethylacetate, butyl acetate, 1-methoxy propyl acetate, ethylene glycol, dimethyl ether, and combinations thereof.

In one embodiment, other fillers may be used together with the spherical boron nitride of this invention. These include but are not limited to, metal oxides such as aluminum oxide, zinc oxides and silicon oxides, silicates such as sodium silicates, metal nitrides such as boron nitrides (hexagonal or cubic), aluminum nitride (coated or uncoated) and silicon nitrides, metal carbides such as silicon carbide, coated metal nitrides such as silica coated aluminum nitride particles, metals such as silver, copper, aluminum, and alloys thereof, aluminum spheres, silver coated copper, silver coated aluminum, silver coated ceramics or glasses, ceramic or glass or organic surfactant coated metal particles such as borate coated silver particles, alumina coated silver particles, silica-glass coated silver particles, palmitic acid coated aluminum particles, aluminum particles with a natural oxide layer, diamonds, carbon fibers such as graphite fibers, carbon nanotubes and carbon fibers coated with metals, TiB₂, metal alloys, conductive polymers or other composite materials.

In one embodiment, the optional filler is a sodium silicate in the form of a liquid comprising water and Na₂O·XSiO₂, from Occidental Chemical Corp. as Siliceous-40.

In one embodiment, the "optional fillers" include a fusible, i.e., low melting point metal or metal alloy of the type commonly used as solders and thermal links or fuses. Particularly, the metal material is used in the dispersed phase with the spherical boron nitride agglomerates. In one embodiment, the dispersed metals comprise materials with melting ranges from about -50 to 260°C, usually containing one or more of gallium, bismuth, lead, tin, cadmium, and indium, but also may contain one or more other metals such as zinc, silver, copper, and antimony. In one embodiment, the alloy is a gallium, a gallium-indium alloy, a gallium-tin alloy, a gallium-indium-tin alloy or a gallium-indium-tin-zinc alloy.

In one embodiment of the invention, the spherical boron nitride may be used in conjunction with nano-sized filler materials, e.g., filler particles in the 1-1,000 nanometer ("nm") range. A commercially available example of such filler particles is NANOPOX, e.g. NANOPOX XP 22, by Hans Chemie, Germany. NANOPOX fillers are monodispersed silica filler dispersions in epoxy resins, at a level of up to about 50% by weight. NANOPOX fillers ordinarily are believed to have a particle size of about 5 nm to about 80 nm.

In one embodiment, fillers in the form of carbon fibers in the range of 0.05 to 20 by weight of the final composition can be added to further improve the thermal conductivity. An example is "vapor grown carbon fiber" (VGCF) as available from Applied Sciences, Inc., Cedarville, Ohio. VGCF, or "carbon micro fibers", which are a highly graphitized type by heat treatment (thermal conductivity = 1900 W/m°C) and available in varying lengths and diameters, e.g., 1 mm to tens of centimeters in length and from under 0.1 to over 100 µm in diameter.

In one embodiment, optional fillers including fused metals and /or metal alloys are loaded in an amount of about 5 to 95 wt. % of the final composition. In a second embodiment, the fused metal is an indium alloy in an amount of about 35 to 95 wt. % of the total thermal conductive composition. In a third embodiment, the fused metal is an indium alloy in an amount of about 50 to 95 wt. % of the total thermal conductive composition.

In one embodiment, pigments and/or pigments mixed with a carrier fluid (such as in a pigment masterbatch) are added to the formulation. In another embodiment, flame-retardants can be used in the final formulation in a range between about 0.5 to 20 wt.% relative to the amount of the final formulation. Examples of flame retardants include phosphoramides, triphenyl phosphate (TPP), resorcinol diphosphate (RDP), bisphenol-α-diphosphate (BPA- DP), organic phosphine oxides, halogenated epoxy resin (tetrabromobisphenol A), metal oxides, metal hydroxides, and combinations thereof. In a third embodiment, adhesion promoters, including but not limited to alkoxysilane compounds, polysiloxane fluids containing alkoxy moieties, titanates may be added. Compounds that modify the curing profile of the resin may also be included.

Applications of the Thermally Conductive Composition of the Invention. In one embodiment, the thermally conductive formulation may be applied as is, i.e., as a grease, gel and phase change material formulations. In another embodiment, the compositions can be pre-formed into sheets or films and cut into any desired shape for positioning between electronic components. Alternatively, the composition can be pre-applied to either the heat generating or heat dissipating unit of a device, B-staged and stored. The assembled unit can then be attached to a heat dissipating or heat generating unit and cured to completeness.

Where the polymer matrix is not a curable polymer, the resulting thermal interface composition can be formulated as a gel, grease or phase change materials that can hold components together during fabrication and thermal transfer during operation of the invention. The phase change materials may comprise wax compounds, polyalkylsiloxanes, siloxanes containing silicon-phenyl moieties, oligo- or low molecular weight polyolefins, C₁₂-C₁₆ alcohols, acids, esters, methyl triphenyl silanes, combinations thereof, and the like, but not limited thereto. When the polymer matrix is not curable or hardenable, common organic liquids such as ionic liquids can also be used as the resin material.

In one embodiment, the composition is applied in the form of a two-layer adhesive construction. The polymeric base and optionally an inner layer of the base comprise an adhesive that is cured to a composition that is non-tacky at the normal temperatures of heat sink article use. The base comprises an outer layer which comprises an adhesive layer that remains tacky at the normal temperatures of heat sink article use, such as a pressure-sensitive adhesive (PSA). As discussed above, the polymeric base component may be provided as a silicone, polyurethane, acrylic, acrylic pressure-sensitive adhesive, etc., the polymeric component alternatively may be formulated as a phase-change material (PCM).

In another embodiment, the composition is applied in an uncured or flowable state between a heat generating unit and a heat-dissipating unit. The composition is then cured or hardened into a thermal adhesive or a gel. Examples of the various end-use applications follow.
a. Thermally Conductive Underfill. In one application, the thermally conductive composition is used as an underfill material. In one example, the underfill compound (excluding the spherical boron nitride filler) comprises 10 to about 70 weight percent of an epoxy component; about 1 to about 15 wt. percent of a latent fluxing agent; and about 3 to 30 weight percent of a latent curing agent component. In one embodiment, the latent-fluxing agent comprises an anhydride component. In another embodiment, the latent-fluxing agent is selected from the group of compounds which form a phenolic compound or a carboxylic acid-containing compound when heated above 140 °C. In yet another embodiment, the latent curing agent component includes a complex of a portion of the acidic fluxing agent and a salt of a nitrogen-containing component.
b. Thermally Conductive Formed-in-Place Gel. In embodiments wherein the polymer matrix containing the spherical boron nitride agglomerates does not cure or harden into a solid, the resulting thermally conductive composition can be formulated as a gel that can hold components together during fabrication and thermal transfer during operation of the device.
   In one embodiment, the composition is in the form of a dispensable gel, which can be dispensed under applied pressure as a bead or mass from a nozzle or other orifice. The applied pressure may be from an equipment such as a gun or syringe, or metering equipment such as a pump or a proportioning cylinder. The composition so dispensed is conformal so as to be capable of filling gaps between surfaces for circuitry components, boards, and housings of electronic devices.
   In one embodiment, the gel material is produced by combining at least one rubber compound with at least one amine resin. This interface material takes on the form of a liquid or "soft gel". The gel state is brought about through a crosslinking reaction between at least one rubber compound composition and at least one amine resin composition.
   The rubber composition can be either saturated or unsaturated. Saturated rubber compounds are preferred in this application because they are less sensitive to thermal oxidation degradation. Examples of saturated rubbers that may be used are ethylenepropylene rubbers, hydrogenated polypropadiene mono-ol, hydrogenated polypentadiene mono-ol), hydrogenated polyalkyldiene "diols" (such as hydrogenated polybutadiene diol, hydrogenated polypropadiene diol, hydrogenated polypentadiene diol) and hydrogenated polyisoprene. Amine or amine-based resins are added or incorporated into the rubber composition to facilitate a crosslinking reaction between the amine resin and the primary or terminal hydroxyl groups on at least one of the rubber compounds.
   In one embodiment, the crosslinkable thermally conductive material is formed by crosslinking the saturated rubber compound and the amine resin to form a crosslinked rubber-resin mixture, adding the spherical boron nitride filler (and other optional fillers) to the crosslinked rubber-resin mixture, and adding a wetting agent to the crosslinked rubber-resin mixture. This method can also further comprise adding at least one phase change material to the crosslinked rubber-resin mixture. The material can be provided as a dispensable liquid paste to be applied by dispensing methods and then cured as desired. It can also be provided as a highly compliant, cured, elastomer film or sheet for pre-application on interface surfaces. It can further be provided and produced as a soft gel or liquid that can be applied to surfaces by any suitable dispensing method.
   In one embodiment, the gel may be formed through reactions between a siliconhydride fluid with a vinyl-stopped polydimethylsiloxane or with other functionalized polyalkysiloxane fluids.
   In another embodiment, the gel material may be formed through transition metal catalyzed crosslinking reaction between a vinyl-functionalized organosiloxanes and a crosslinking agent. One example of the crosslinking reacton is a platinum-catalyzed hydrosilylation reaction between a vinyl-terminated polydimethylsiloxane and a poly(dimethyl-co-methylhydrido)siloxane. The gel may be dispensed in an uncured form, interposed between a heat generating and a heat dissipating unit and then cured in place. Alternatively, the gel may be pre-cured into a liquid gel form, and applied as is without requiring further curing.
c. Thermally Conductive Grease: In one embodiment, the spherical boron nitride material is used as a filler component in a thermally conducting grease comprising an uncrosslinked or lightly cross-linked liquid silicone carrier and optionally a bleed inhibiting agent. The grease may be formulated to be inherently tacky or sticky to enable one or both of the surfaces and of the grease layer to adhere, such as by means of surface tension, at room temperature under a low applied pressures of about 35 kPa (5 psi) or less to the surface of the heat sink, spreader, or the like.
   As loaded with the spherical boron nitride agglomerate fillers, the thermal grease in one embodiment exhibits an in-situ thermal conductivity per Netzsch's Microflash 300 of about 0.1 to 15W/m·K and a thermal impedance of less than about 6.45 °C·cm²/W (1°C in²/W).
   In theory, any liquid silicone materials can be used so long as it is resistant to drying out over extended periods of time, retains the spherical boron nitride filler and optional fillers without separation, and is chemically inert.. In one embodiment, the liquid organo-silicone compound has a viscosity of from about 10 centistokes to about 10,000 centistokes at 25°C. In one embodiment, the liquid silicone carrier is polydimethylsiloxane having a viscosity of about 100 centistokes at 25°C. In one embodiment, a bleed inhibiting agent in an amount of 0.1 to about 4 wt%. may be used. The bleed inhibiting agent comprises silica fibers of less than 1 micron in size, and substantially all of which are less than 5 microns may be used.
d. Thermally Conductive Foil. In one embodiment, the composition is used as a thermally conductive foil with a backing or removable liner, which can be subsequently die cut, if desired. The removable liner can be applied to exposed surfaces of the compound to facilitate handling, shipping and storage, but may be removed prior to the material being applied between the electronic components and /or the electronic component and the heat sink.
e. Pressure Sensitive Adhesive or Film. In one embodiment of the invention, the pressure sensitive thermally conductive material is formed by coating the composition containing the spherical boron nitride filler and resin onto a releasable surface and dried or cured to form a form stable material. If desired, a releasable coversheet may be applied to one or both sides of the tape to keep it from prematurely sticking to a surface, to allow it to be rolled up on itself and/or to keep it from picking up dirt, dust and often debris which could interfere with the thermal capabilities of the tape in use. As used herein, a pressure sensitive adhesive means an adhesive that is normally tacky at the use temperature and bonds to a surface upon application of pressure.
   In one embodiment, the thermally conductive material is configured as a film or a sheet of two sides, one side to be applied onto a support sheet such as an aluminum foil, and the other side to be applied onto a cover / release / protective liner or film with a weakened interface to allow the film to be peeled off easily in applications. The weakened interface may be created or weakened after the thermally conductive material is applied onto the sheet / film by a heat generating or a heat transfer device. The weakening can be done by methods including the use of chemicals, UV light, heat, freezing, etc. In one embodiment, the material is configured as a tape that can be applied directly to interface surfaces or electronic components.
   In one embodiment, the support or reinforcement sheet or film has a thickness of about 12.7 to 127 µm (0.5 to 5 mil), with a thickness of about 25.4 to 76.2 µm (1 to 3 mils) if metal foil is used.
   In one embodiment, if metal foil is used as a support sheet and if a metallic filler is used in conjunction with the spherical boron nitride agglomerate filler in the thermally conductive composition, the support sheet may be coated or treated with a low metallic alloy for a layer of less than about 50.8 µm (2 mils (1 mil = 25 microns)) thick to promote the adhesion of the support sheet with the thermally conductive composition.
   In one embodiment, the cover / protective film is a thermoplastic adhesive film selected from the group of linear saturated polyesters, PTFE, polyvinyldifluoride, and the like. In another embodiment, the film is an adhesive / releasable liner comprising polyethylene-coated paper. In another embodiment, the cover / protective film comprises a release coating such as polydimethyl siloxane, fluorosilicone, or non-silicone release coating.
   In one embodiment, the thermally conductive composition is in the form of a multilayer laminate comprising 10 - 50 wt. % spherical boron nitride agglomerates with a film of adhesive bonded thereto.
f. Thermally Conductive Pads: In one embodiment, the spherical boron nitride agglomerates are used as filler in a thermally conductive paste, liquid, or grease compound. The compound is next applied onto thermal pad carriers such as fiberglass, carbon, or polymer fabrics, e.g., for thermal pads with low thermal resistance. In one example, the support structure comprises carbon fiber fabric as a support structure. Carbon fiber fabric is commercially available from Carbon Composites Company and Morton Thiokol, comprising at least 50% carbon fiber by weight. The pads may be cut into different sizes and shapes, with thicknesses in one embodiment ranges from 127 to 3175 µm (5 mil to 125 mil).

In one embodiment, the paste or grease compound is combined with a quantity of a matrix forming flowable plastic resin such as microwax, silicone wax, or other silicone polymer to form a thermally conductive mechanically compliant pad. In another embodiment, the compound may be applied directly onto a heat transfer surface via a coating technique such as hot stamp, screen printing, or other means to form thermal pads.

In one embodiment, the thermal pad employing spherical boron nitride agglomerate fillers has a thermal conductivity of at least about 0.5 W/m-K. In one embodiment, the pad further comprises about 10 to 90 wt. % of a metal or metal alloy in the polymer matrix with the alloy having a melting temperature of about -10 to 120°C. In a second embodiment, the metal alloy is indium alloy containing quantities of gallium, bismuth, tin, and / or zinc, in the form of particles averaging about 1 to 100 microns in size.

In one embodiment, the paste composition comprises about 20 to 50 wt. % of a matrix of a silicone wax or microwax, about 5 to 30 wt. % of the spherical boron nitride agglomerate filler, about 30 to 70 wt. % of a metal alloy or mixtures thereof, and about 2 to 10 wt. % of a surface active agent. The surface active agent is used on the surface of the metal particles, creating a durable hydrophobic barrier. Additionally, the surface active agent compatibilizes the metal particles with the polymer matrix and reduce particle aggregation. In one embodiment, the surface active agent is selected from the group of silanes, titanates, zirconates, and mixtures thereof. In another embodiment, the surface active agent is selected from alkyl functional silanes such as octyl triethoxy silanes (ETES) or methyl trimethoxy silane (MTMS).

Method For Formulation the Thermally conductive Composition. The manner in which the filler is combined with the matrix is critical not only to the rheology (e.g., viscosity) of the final formulation but also the formulation's in-situ thermal performance. The fillers may be used as received or may be treated prior to or during mixing. Filler treatments include, but are not limited to, ball-milling, jet-milling, chemical or physical coating or capping via procedures such as treating fillers with chemicals such as silazanes, silanols, silane or siloxane compounds or polymers containing alkoxy, hydroxy or Si-H groups and any other commonly used filler-treatment reagents, and any other procedures commonly adopted by those skilled in the art. The final formulation can be hand-mixed or mixed by standard mixing equipment such as dough mixers, change can mixers, planetary mixers, twin screw extruders, two or three roll mills and the like. The blending of the formulations can be performed in batch, continuous, or semi-continuous mode by any means used by those skilled in the art.

The bond line thickness can be further controlled by the viscosity of the thermally conductive composition and filler treatments as well as pressure used to interpose the thermally conductive material. Viscosity may be modified by both adjusting the composition of the thermally conductive composition, as well as the processing conditions. For example, the viscosity of the composition can be adjusted by the amount of filler loading, the ionic contents in the filler, the surface area of the filler, the particle size distribution of the filler, the functional groups on the surface of the filler, the viscosity and purity of the polymer matrix utilized, the amount of adhesion promoters and any other methods known to those skilled in the art. The viscosity may also be modified by adjusting processing conditions such as the mixing speed, mixing time, temperature of mixing, level of vacuum, order of addition, extent of filler treatment and any other processing parameters known to those skilled in the art. The minimum achievable bond line thickness may also be affected by mechanical procedures such as ball-milling of fillers. Suitable viscosities to obtain the bond line thicknesses range from about 5,000 to about 3,000,000 cps, with a viscosity ranging from about 10,000 to about 200,000 cps being preferred. The viscosity is measured at a shear rate between 1-10/sec.

Properties of the Composition In one embodiment of the invention, the thermally conductive composition is characterized with a heat resistance property, e.g., resistance to heat dissipation, in the amount of 1-80 mm²K/W.

In another embodiment, the thermally conductive composition is characterized as being flexible so as to reduce stress generated by any differences in the coefficient of thermal expansion (CTE) between the heat sink and the structures to which it is attached. For example, the CTE of the heat sink may be larger than the CTE of the package to which the heat sink is attached. Since stress is the product of the CTE times the modulus, the low modulus of the thermal interface material reduces stress. In addition, viscoelastic behavior in one embodiment of the composition allows stress to be relaxed over time. In one example, the flexural modulus (using a single cantilever beam method such as ISO-6721-1) of the polymer mixed with spherical boron nitride filler when measured at 21 °C (70° F) is generally below about 10 GPa. In a second embodiment, the flexural modulus is below about 7 GPa. In a third embodiment, below about 5 GPa. In a fourth embodiment, the flexural modulus is even below about 0.5 GPa.

In one embodiment, besides the advantages of having properties which allow fully conformable for lowered contact resistance and more efficient heat transfer, the thermally conductive composition of the invention may be particularly formulated for use in applications requiring thin minimum bondline thicknesses ("MBLT"). The choice of particle size of the spherical boron nitride filler depends on the application. For example, spherical boron nitride particles having a major dimension of at least about 1-2 µm and about 30 µm or below, are suitable for articles such as grease, phase change material, liquids, adhesives, gels and tapes. For applications wherein the bond line will be in the 25 to 100 µm range (such as found between a central processing unit (CPU) and a heat sink), spherical boron nitride particles of larger size can be used, e.g., in the range of 15 - 75 µm. In applications wherein a larger gap exists between the hot and cold substrates, spherical boron nitride agglomerates of sizes such as 50 to 100, or even 250 µm may be used in thick products such as silicone pads. Generally, larger particles are used to increase bulk conductivity, counteracted by the consideration that the maximum dimension of the particles or particle aggregates can not exceed the desired gap size between the two mating surfaces.

In one embodiment of the invention, the composition displays a bond line thickness (BLT) of greater than 125 µm (5 mils) and less than 510 µm (20 mils). In a second embodiment, the composition displays a BLT of about 0.508 µm (0.02 mil) to about 81.28 µm (3.2 mil). In a third embodiment, the composition has a BLT of 177.8 to 1270 µm (7 to 50 mils). In a fourth embodiment, a BLT of 10 to 80 mils. In one embodiment, the composition exhibit a thermal impedance, such as in accordance with ASTM D5470 of between 0.065 - 0.13°C·cm²/W (0.01 - 0.02 °C·in²/W).

EXAMPLES Unless specified otherwise in the examples, the diffusivity and in-situ thermal conductivity is determined by laser flash (Netzsch Instrument, Microflash 300.) The in-situ thermal resistivity is determined by a software macro provided with the Microflash™ instrument. To measure the bulk thermal conductivity, a 2" disc is prepared from the example, and the bulk thermal conductivity is measured on a Holometrix TCA300 instrument. Alternatively, Netzsch's Microflash 300 can also be used to obtain the bulk thermal conductivity values. The in-situ thermal resistance is determined by dividing the bondline thickness by the in-situ thermal conductivity.

Example 1: In this example of a non-silicone / non-wax thermally conductive composition, polyol ester in an amount of about 99 wt. percent is first mixed with an antioxidant in an amount of about 1 wt. percent to form a pre-blend (which pre-blend makes up about 8-12 wt. percent of the thermally conductive compound). Spherical boron nitride filler in the amount of about 10-80 wt. percent is then added to the preblend, along with a high viscosity oil in the amount of about 2.5-5.5 wt. percent. Further, in one embodiment there is added a surfactant in the amount of about 0.2 wt. percent, a polystyrene-based polymer in the amount of about 3 wt. percent, and a solvent in the amount of about 1 wt. percent. In an alternate embodiment, instead of the polymer, solvent and surfactant, there is added aluminum silicate in an amount of about 5.2 wt. percent of the compound.

GEL EXAMPLES: In the following examples, the thermally conductive compositions of the invention are in the form of a gel, employing the following components:
A-1: a 400 cps vinyl-terminated polydimethylsiloxane fluid (trade name SL6000, commercially available from GE Silicones in Waterford, NY).
B-1: a silicon hydride fluid with an average chain length of about 21, and a hydride content of about 0.19% to about 0.25% (trade name 88405 from GE Silicones)
B-2: a silicon-hydride-terminated polydimethylsiloxane fluid with an average molecular weight of about 6000, and an average hydride content of about 0.04% (DMS-H21, commercially available from Gelest, Inc. of Morrisville, PA.)
C-1: Teco 2003124A, boron nitride powder in spherical agglomerate form, available from GE Advanced Ceramics of Strongsville, OH, having an average particle size of 60 - 70 microns.
C-2: TECO 2004112-B, a boron nitride powder from GE Advanced Ceramics, average particle size 25 - 30 microns.
C-3: PT120, platelet-like boron nitride powders from GE Advanced Ceramics.
D-1: a stock solution of a tetramethyltetravinylcyclotetrasiloxane-complexed platinum catalyst and Irgafos 168 in vinyl-terminated polydimethylsilxoane SL6000 ([Pt] = 480 ppm, molar ratio of Irgafos : Pt = 2:1)
E-1: A580, a polyalkylsiloxane silicone fluid containing alkoxy groups from GE Toshiba of Japan.

Gel Example 1: In this example, a stock solution, I, consisting of components A-1 and B-1 is prepared (A-1 : B-1 is approximately 48.29 : 1 by weight). A portion of the stock solution, I, is combined with component C-1 on a high-speed mixer till a visually homogeneous mixture is obtained. The mixture is degassed overnight in a 75°C oven connected to house vacuum, and then cooled to room temperature. A stock solution, II, consisting of Components B-2, D-1 and E-1 is prepared (B-2 : E-1 : D-1 ∼ 8.86: 4.03 : 1 by weight). An appropriate amount of stock solution II is then added to the degassed mixture above. Afterwards, the mixture is blended on a high-speed mixer (FlackTek Inc., Model # DAC400FV) for 5 seconds at 750 rpm. The formulation is transferred to a syringe, and degassed over the weekend at room temperature. The resulting gel compositions are cured between an aluminum coupon and 3 silicon coupon under a 68.95 kPa (10 psi) pressure at 150°C for 2 hours. The resulting sandwiched structures are tested under 206.84 kPa (30 psi) pressure. The final composition and the thermal performance are listed in Table 1.

Gel Examnle 2: In this example, a gel composition is prepared in the same way as in Gel Example 1, except that Filler C-2 is used. The formulation is transferred to a syringe, and degassed over the weekend at room temperature. The resulting gel compositions are cured between aluminum coupon and a silicon coupon under a 68.95 kPa (10 psi) pressure at 150°C for 2 hours. The resulting sandwiched structures are tested under 206.84 kPa (30 psi) pressure. The final composition and the thermal performance are listed in Table 1.

Gel Comparative Example 1: A gel composition is prepared in the same way as in Gel Example 1, except that Filler C-3 is used. The formulation is transferred to a syringe, and degassed over the weekend at room temperature. The resulting gel compositions are cured between an aluminum coupon and a silicon coupon under a 68.95 kPa (10 psi) pressure at 150°C for 2 hours. The resulting sandwiched structures are tested under 206,84 kPa (30 psi) pressure. The final composition and the thermal performance are listed in Table 1.

As seen in Table 1, compositions containing spherical BN C-1 and C-2 give higher in-situ thermal conductivity than comparable composition containing platelet-like BN C-3.

**Table 1**

| | Examples | | | |
|---|---|---|---|---|
| Composition: | Gel 1 | Gel 2 | Comparative Gel 1 | |
| A-1 | 100 | 100 | 100 | |
| B-1 | 2.1 | 2.1 | 2.1 | |
| B-2 | 11.5 | 11.5 | 11.4 | |
| C-1 (PTX60) | 68 | - | - | |
| C-2 (PTX25) | - | 68 | - | |
| C-3(PT120) | - | - | 68 | |
| D-1 | 1.3 | 1.3 | 1.3 | |
| E-1 | 5.2 | 5.2 | 5.2 | |
| Wt% filler | 36.2% | 36.2% | 36.2% | |
| Vol% filler | 20% | 20% | 20% | |

| Thermal Performance: | | | | |
|---|---|---|---|---|
| Sandwich material | Al-TIM-Si | Al-TIM-Si | Al-TIM-Si | |
| Curing Condition | 150°C, 2 hours, | 150°C, 2 hours, | 150°C, 2 hours, | |
| kPa (psi) | 68.95 (10) | 68.95(10) | 68.95 (10) | |
| Test Pressure /kPa (psi) | 206.84 (30) | 206.84 (30) | 206.84 (30) | |
| Bondline Thickness / µm (mils) | 50.8±7.6 (2.0±0.3) | 30.5±2.5 (1.2±0.1) | 17.8±2.5 (0.7±0.1) | |
| range / µm (mils)* | 38.1 - 55.9 (1.5-2.2) | 27.9 - 33.0 (1.1-1.3) | 15.2 - 22.86 (0.6-0.9) | |
| In-situ Resistivity | Thermal @25°C | 8.6±2.0 | 7.4 ± 1.2 | 8.0 ± 2.3 |
| (mm²-K/W)* | | (6.2-11) | (6.3 - 9.0) | (6.5 - 11.4) |
| In-situ Conductivity | Thermal @25°C | 5.9±0.6 | 4.3 ± 0.8 | 2.4±0.3 |
| (W/mK)* | | (5.1-6.5) | (3.6 - 5.1) | (1.9-2.6) |

| | | | | |
|---|---|---|---|---|
| *Numbers in brackets represent the range of values obtained; 4 samples for each composition | | | | |

ADHESIVE EXAMPLES. In the following examples, adhesive compositions are prepared.

Adhesive Example 1: In this example, a composition is prepared using spherical boron nitride agglomerates from GE Advanced Ceramics of Strongsville, OH (PTX60, TECO 2003124A, average particle size 60 micron, GE Advanced Ceramics). The BN powder is mixed in a lab scale Ross mixer (1 quart capacity) at approximately 60 rpm with 100 parts of vinyl-stopped polydimethylsiloxane fluid (350-450 cSt, approximately 0.48 weight percent vinyl) at 25-35° C., and atmospheric pressure until a smooth consistency is obtained. To this mixture is added 0.21 parts of a pigment masterbatch (50 weight percent carbon black and 50 weight percent of a 10,000 cSt vinyl-stopped polydimethylsiloxane fluid) and a portion of the hydride fluid is added (0.66 parts of hydride functionalized polyorganosiloxane fluid, approximately 0.82 weight percent hydride.) The formulation is mixed at approximately 60 rpm for 6 minutes to incorporate the fluids and pigment. The temperature is then raised to 140-160° C. and the mixture is stirred at approximately 60 rpm for an additional 1.5 hours.

The formulation is cooled to approximately 30° C. and the following materials are added: 0.16 parts triallyl isocyanurate, 0.02 parts 2-methyl-3-butyn-2-ol, and 0.03 parts of a tetramethyltetravinylcyclotetrasiloxane-complexed platinum catalyst (from GE Silicones of Waterford, NY as 88346). The materials are incorporated by stirring for 8 minutes at approximately 60 rpm.

Additional materials are then added to the mixer: 0.92 parts of a first adhesion promoter (from GE Toshiba of Japan as YC9632), 0.60 parts of a second adhesion promoter (glycidoxypropyltrimethoxysilane), and the second portion of the hydride fluid is added (1.34 parts of hydride functionalized polyorganosiloxane fluid, approximately 0.82 weight percent hydride). The additional materials are incorporated by stirring for 5 minutes at approximately 60 rpm. The final formulation is mixed for an additional 3 minutes at approximately 60 rpm and at a vacuum pressure of 84.7 - 101.6 kPa 25-30 inches Hg. The formulation is removed from the mixer and stored in a refrigerator (at -40 to 0°C.) until needed to form a thermal interface material ("TIM").

To form the TIM Sandwich, the mixture is interposed between AlCr and Si coupons and cured under 68,9 kPa (10 psi) pressure. Prior to dispensing the material from a syringe to place the TIM between the two coupons, the material is filtered through a 100 mesh filter screen to remove any foreign contaminants and then placed under vacuum for 3 minutes at 84.7 - 101.6 kPa (25-30 inches Hg) to remove any residual entrapped air. A total of 7 samples are prepared utilizing the formulation between the AlCr and Si coupons.

Comparative Adhesive Example 1: A formulation is prepared as described above, except that a Boron Nitride powder of a non-single crystal, non-flake-type, with an average particle size of 150 microns is used (PT350 from GE Advanced Ceramics). The bulk thermal conductivity and the in-situ thermal performance of the formulation is determined as outlined in Adhesive Example 1. A total of 5 samples are prepared utilizing the formulation between the AlCr and Si coupons.

Comparative Adhesive Example 2: In the example, a formulation is prepared as described with the spherical BN agglomerate example (Adhesive Example 1), except that Boron Nitride single crystal, flake-type powder with an average particle size of 44 microns is used (PT110, from GE Advanced Ceramics). A total of 5 samples are prepared utilizing the formulation between the AlCr and Si coupons.

Comparative Adhesive Example 3. A formulation prepared in the same manner as Adhesive Example 1 is used. The formulation is mixed with the formulation prepared in Comparative Example 2 in a 2:1 ratio on a speedmixer. A total of 5 samples are prepared utilizing the formulation between the AlCr and Si coupons.

Comparative Adhesive Example 4. The formulations prepared in Adhesive Example 1 and Adhesive Comparative Example 2 are mixed in a 1:1 ratio on a speedmixer. A total of 5 samples are prepared utilizing the formulation between the AlCr and Si coupons.

Comparative Adhesive Example 5. The formulation with spherical BN agglomerates (Adhesive Example 1) is mixed with the formulation prepared in Comparative Example 2 in a 1:2 ratio on a speedmixer. A total of 5 samples are prepared utilizing the formulation between the AlCr and Si coupons.

**Table 2**

| Example | 1 | Comp. 1 | Comp. 2 | Comp. 3 | Comp. 4 | Comp. 5 |
|---|---|---|---|---|---|---|
| Filler in wt.% | 50 | 50 | 50 | 50 | 50 | 50 |
| Filler type | PTX60 | PT350 | PT110 | 2:1 PTX60: PT110 | 1:1 PTX60: PT110 | 1:2 PTX60: PT110 |
| Bulk thermal conductivity @75C in W/mK | 1.3 | 0.9 | 0.6 | - | - | - |
| Bondline thickness, range /µm (mil) | 71.12±3.05 (2.80±0.12) | 94.49±12.2 (3.72 ± 0.48) | 30.48±5.84 (1.20±0.23) | 63.50 ± 3.81 (2.50 ± 0.15) | 55.88±1.27 (2.20±0.05) | 57.91±8.38 (2.27±0.33) |
| | 65.02-75.43 (2.56-2.97) | 86.10-116.07 (3.39-4.57) | 23.37-38.10 (0.92-1.50) | 58.93 - 69.08 (2.32-2.72) | 54.62-57.66 (2.15-2.27) | 48.77-69.34 (1.92-2.73) |
| In-situ thermal resistivity | 40 ± 2 | 88 ± 7 | 53 ± 4 | 42 ± 2 | 42 ± 5 | 54 ± 9 |
| @25°C range mm²·K/W | (36-42) | (81 - 97) | (47 - 57) | (39 - 43) | (37 - 49) | (44 - 64) |
| In-situ thermal conductivity | 1.80 ± 0.12 | 1.07±0.11 | 0.58 ± 0.07 | 1.51 ± 0.09 | 1.34 ± 0.15 | 1.08 ± 0.05 |
| @25°C W/m.K | (1.65-2.01) | (0.93 - 1.22) | (0.50-0.67) | (1.43 - 1.64) | (1.15 - 1.54) | (1.01-1.14) |

As shown in Table 2 above, examples of thermally conductive adhesives containing the spherical boron nitride agglomerates show the highest bulk thermal conductivity, the lowest in-situ thermal resistances and the highest in-situ thermal conductivity. In the comparative examples wherein the spherical boron nitride agglomerates are replaced by the boron nitride fillers of the prior art, the in-situ thermal conductivities start to decrease and the thermal resistivities start to increase.

Adhesive Example 2. In the example, Component A-1 (a 400 cps vinyl-terminated polydimethylsiloxane fluid, SL6000, GE Silicones) is first mixed with PTX25 (spherical BN with an average particle size of 25 - 30 microns) on a high-speed mixer in portions, and degassed overnight in a 75°C vacuum oven connected to house vacuum. The mixture is then cooled to room temperature. In the next step, the followings are added to the mixture including, component B-1 (a silicon hydride fluid with an average chain length of about 100, and a hydride content of about 0.72% to about 1%, 88466, GE Silicones), component G (a mixture of 75:8 by weight triallylisocyanurate (TAIC) to 2-methyl-3-butyn-2-ol), component F-1 (a stock solution of a tetramethyltetravinylcyclo- tetrasiloxane-complexed platinum catalyst from GE Silicones as "88346" in vinyl-terminated polydimethylsilxoane SL6000 ([Pt] = 570 ppm), component H-1 (a mixture of A501S from GE Toshiba to glycidoxypropyltrimethoxysilane in 44:29 weight ratio). The composition is first mixed with a spatula, and then thoroughly mixed on the speedmixer (FlackTek Inc., Model # DAC400FV) at 1000 rpm for 10 seconds. The mixture is then degassed at room temperature for 15 - 24 hours (house vacuum). The composition is listed in Table 3.

The mixture is then interposed between two metal coupons with a 10 psi pressure for 1 second and cured under a pressure of 10 psi at 150°C over 2 hours. The sandwich structures are tested for diffusivity and thermal resisistivity. No external pressure is exerted during the measurement for adhesives. 4 - 5 samples are prepared utilizing the formulation between the AlCr and Si coupons. The thermal performance data are listed in Table 3.

Adhesive Comparative Example 6. A composition is prepared in the same way as in Example 2, except that alumina particles (AS40, Showa Denko, average particle size 12 microns) are used. The final composition and the thermal performance data are listed in Table 3.

Higher loadings of alumina particles are required to achieve performance similar to formulations containing spherical boron nitride of the present invention.

**Table 3**

| | Examples | |
|---|---|---|
| | Adhesive 2 | Comparative 6 |
| A-1 | 100 | 100 |
| B-1 | 2 | 2 |
| Spherical BN (PTX25) | 58 | 0 |
| Alumina (AS40) | 0 | 600.5 |
| G | 0.67 | 0.58 |
| F-1 | 1.04 | 0.89 |
| H-1 | 5.2 | 5.2 |
| Wt% of fillers | 34.8% | 84.7% |
| Vol% of filler | 19% | 58% |
| Thermal Performance: | | |
| Sandwich Material | Al-TIM-Si | Al-TIM-Si |
| Assembly/Cure pressure kpa (psi) | 68.94/68.94 (10/10) | 68.94/68.94 (10/10) |
| Bondline Thickness, range, / µm (mils)* / µm | 55.88±10.16 (2.2 ± 0.4) | 55.88±10.16 (2.2±0.4) |
| | 48.26-71.12 (1.9-2.8) | 48.26-71.12 (1.9-2.8) |
| In-situ Thermal Resistivity @25°C (mm2-K/W) * | 42 ± 5 (35-48) | 42±4 (38-48) |
| In-situ Thermal Conductivity @25°C (W/mK)* Thermal Conductivity @25°C (W/mK)* | 1.3 ± 0.1 (1.2-1.5) | 1.3 ± 0.2 (1.2-1.5) |

| | | |
|---|---|---|
| *Numbers in brackets represent the range of values obtained; 5 samples for each composition | | |

SILICONE PAD EXAMPLES Thermally conductive spherical Boron Nitride (PTX60 or PTX25 GE Advanced Ceramics) is mixed in a lab scale FlackTek speed mixer at approximately 3500 rpm with Sylgard 184 Silicone Resin and curing agent Sylgard 184. The filler content of spherical BN ranges from 35 to 85 wt.% (20 to 70 vol.%). The mixture is placed in a 7,62 x 12,7 cm (3"x5") rectangular mold and pressed at 125°C for 45 minutes to form pads of 0.5 to 1.5 mm in thickness. The bulk thermal conductivity is measured via a Mathis ™ Hot Disk Thermal Constant Analyzer. The results are presented in Table 4.

Comparative Examples. A formulation is prepared as described in Example 4, except that a different Boron Nitride powder was used (PT110, single crystal, flake-type) with an average particle size of 44 microns.

**Table 4**

| Example | 4 | 4 | Comp. | 4 | 4 | Comp. |
|---|---|---|---|---|---|---|
| Filler vol. % | 30 | 30 | 30 | 40 | 40 | 40 |
| Filler Type | PTX60 | PTX25 | PT110 | PTX60 | PTX25 | PT110 |
| Thermal cond @25C W/m-K ±0.2 - 0.3 | 9.2 | 6.9 | 3.9 | 13.0 | 11.1 | 5.28 |
| Example | 4 | 4 | Comp. | 4 | 4 | Comp. |
| Filler vol. % | 50 | 50 | 50 | 60 | 60 | 60 |
| Filler Type | PTX60 | PTX25 | PT110 | PTX60 | PTX25 | PT110 |
| Thermal cond @25C W/m·K ±0.2-0.3 | 19.6 | 19.7 | 10.9 | 25.7 | 11.1 | 14.8 |

In Table 5, the spherical BN agglomerated coated with 3 wt.% sorbitan monostearate are used in the silicone pads of the previous examples, with similar excellent thermal conductivity results:

**Table 5**

| Spherical BN containing 3% MS | Filler loading in silicone Pad | Thermal Conductivity (W/mK) |
|---|---|---|
| PTX60S | 40% vol | 12.5 |
| PTX25S | 40% vol | 12.5 |
| PTX60S | 50% vol | 16.0 |
| PTX25S | 50% vol | 13.8 |

GREASE EXAMPLES: In the grease examples, the thermally conductive compound is prepared by blending spherical BN from General Electric Company ("GE Quartz") of Strongsville, OH (PTX60) with micron-sized alumina (DAW05 from Denka, average particle size 5 microns; and AA04 from Sumitomo, average particle size around 0.4 microns) in a silicone fluid (from GE Silicones of Waterford, NY, as SF96-1000, viscosity = 1000cp) on a speedmixer (FlackTek Inc., Model # DAC400FV). The materials are compounded at various loading levels of spherical BN and micro-alumina to make high viscosity pastes. The thermal grease is applied onto an aluminum coupon and another aluminum coupon is placed on the grease with a pressure of 206.84 kPa (30 psi). The three-layered sandwich of aluminum, grease, and aluminum is coated with a thin layer of graphite and placed in a modified sample holder of a laser flash thermal diffusivity instrument. Four bolts are torqued at each corner of the samples to obtain a prescribed pressure on the sample.

Since the thickness of the aluminum coupons are measured beforehand, the thickness of the samples is then measured and the bondline thickness of the grease layer is calculated. The thermal resistance of the thermal grease layer is measured next.

In one example, a grease system containing spherical BN and micron-sized alumina at 79 wt% loading (16 wt% spherical BN and 63 wt% alumina, with a 4:1 weight ratio of DAW05: AA04) is tested in the manner described above. A thermal resistance value of 11 mm²K/W is obtained at a bondline of 48 microns. The in-situ thermal conductivity of the novel grease is measured to be 4.5 W/mK.

Table 6 contains a description of the spherical BN used in the examples. Table 7 shows examples of grease formulations containing spherical BN in Table 6 with other fillers such as zinc oxide. The silicone fluid used in all the examples is SF96-1000 from GE Silicones, Waterford, NY. Zinc oxide was obtained from Alfa Aesar, Lot # L15N34 with particle size of less than 10 microns. In the examples, the following lots of spherical BN from General Electric Company of Strongsville, OH are used. Spherical BN denoted as "S" are spherical BN agglomerated coated with sorbitan monostearate.

**Table 6**

| Notation | Lot # | Description |
|---|---|---|
| PTX60 | 2003-124A | Spherical boron nitride - average. size 60 - 70 µm |
| PTX60S | 2004-1101 | Coated spherical boron nitrides, average. size 60 - 70 µm |
| PTX25-6 | 2004-1112-6 | Spherical boron nitride, average. particle size 25-30 µm |
| PTX25-7 | 2004-1112-7 | Spherical boron nitride with average particle size 25-30 µm |

In the following examples of Table 7, the measurements are under 689,48 kPa (100 psi) load.

**Table 7**

| Grease | Composition* (Balance SF96-1000) | Bond Line Thickness / µm (mils) | In-situ Thermal Conductivity / (W/mk) | In-situ Thermal Resistances / (mm²·K/W) |
|---|---|---|---|---|
| 88-03 | 42.7 wt% ZnO + 27.3 wt% PTX60 | 45.72±5.08 (1.8±0.2) | 6.1 ± 0.8 | 7.4 ± 0.33 |
| 25-03 | 54.8 wt% ZnO + 15.8 wt% PTX60 | 55.88±7.62 (2.2±0.3) | 6.5 ± 0.9 | 8.5 ± 1.0 |
| 80-03Li | 40.9 wt% ZnO + 25.5 wt% PTX60 | 50.80±5.08 (2.0±0.2) | 5.8 ± 0.74 | 8.6 ± 0.5 |
| 27-01 | 54.9 wt% ZnO + 15 wt% PTX60 | 55.88±7.62 (2.2±0.3) | 6.2 ± 0.22 | 9.1 ± 1.1 |
| 27-03 | 60 wt% ZnO + 10.1 wt% PTX60 | 50.80±5.08 (2.0±0.2) | 5.4 ± 0.64 | 9.4 ± 1.7 |
| 7-02 | 66.2 wt% Ag + 10.3 wt% PTX60 | 35.66±5.08 (1.4±0.2) | 3.8 ± 0.6 | 9.6 ± 0.4 |

Table 8 shows examples of thermal greases prepared according to the procedure described above, in which only spherical boron nitride is used as the filler. In the table, blends of spherical boron nitride of different particle sizes are also used. The measurements are at either 206,84 or 689,48 kPa (30 psi or 100 psi).

**Table 8**

| Grease | Composition* | Test pressure / kPa (psi) | Bond Line Thickness / µm (mils) | In-situ Thermal Conductivity / W/m·K) | In-situ Thermal Resistances / mm²·K/W |
|---|---|---|---|---|---|
| 45-03 | 35.1 wt% PTX60 | 689,47 (100) | 40.64 ± 2.54 (1.6 ± 0.1) | 6.6 ± 0.52 | 6.1 ± 0.4 |
| 45-01 | 41.8 wt% PTX60 | 689,47 (100) | 45.72 ± 2.54 (1.8 ± 0.1) | 6.7 ± 0.94 | 6.9 ± 0.7 |
| 45-02 | 34.4 wt% PTX60S | 689,47 (100) | 53.34 ± 3.30 (2.1 ± 0.13) | 7.3 ± 0.54 | 7.2 ± 0.7 |
| 46-01 | 41.6 wt% PTX60 | 689,47 (100) | 43.18 ± 2.54 (1.7 ± 0.1) | 5.5 ± 0.4 | 8.0 ± 0.4 |
| 46-02 | 35.8 wt% PTX60 | 689,47 (100) | 35.56 ± 2.54 (1.4 ± 0.1) | 5.0 ± 0.4 | 6.9 ± 0.5 |
| 46-03 | 46.6 wt% PTX60 | 689,47 (100) | 55.88 ± 5.08 (2.2 ± 0.2) | 7.1 ± 0.6 | 8.0 ± 0.64 |
| 46-04 | 39.6 wt% PTX60 | 689,47 (100) | 38.10 ± 5.08 (1.5 ± 0.2) | 5.6 ± 1.0 | 7.1 ± 1.1 |
| 10-04 | 10.39 wt% PTX60S + 31.18 wt% PTX25-7 | 206.48(30) | 27.94 ± 3.04 (1.1 ± 0.12) | 3.2 ± 0.4 | 8.7 ± 1.0 |
| 9-04 | 10.39 wt% PTX60 + 31.18 wt% PTX25-7 | 206.48 (30) | 33.02 ± 2.54 (1.3 ± 0.1) | 3.7 ± 0.33 | 8.9 ± 0.6 |
| 10-02 | 10.39 wt% PTX60S + 31.18 wt% PTX25-6 | 206.48(30) | 35.56 ± 2.54 (1.4 ± 0.1) | 4.0 ± 0.5 | 9.0 ± 0.8 |
| 9-02 | 10.39 wt% PTX60 + 31.18 wt% PTX25-6 | 206.48 (30) | 48.26 ± 7.62 (1.9 ± 0.3) | 4.9 ± 0.7 | 9.8 ± 1.1 |
| 9-01 | 31.18 wt% PTX60 + 10.39 wt% PTX25-6 | 206.48 (30) | 53.34 ± 3.54 (2.1 ± 0.1) | 4.6 ± 0.44 | 11.5 ± 1.4 |
| 10-03 | 31.18 wt% PTX60S + 10.39 wt% PTX25-7 | 206.48(30) | 53.34 ± 6.10 (2.1 ± 0.24) | 4.6 ± 0.6 | 11.5 ± 1.2 |
| 9-03 | 31.18 wt% PTX60 + 10.39 wt% PTX25-7 | 206.48 (30) | 45.72 ± 5.59 (1.8 ± 0.22) | 4.6 ± 1.1 | 10.1 ± 1.6 |
| 10-01 | 31.18 wt% PTX60S + 10.39 wt% PTX25-6 | 206.48 (30) | 53.34 ± 5.84 (2.1 ± 0.24) | 5.4 ± 1.2 | 10.4 ± 1.4 |

PHASE CHANGE MATERIAL EXAMPLES: In the examples below, compositions in the form of phase change materials are prepared.

Examples labeled PCMs 55-2 comprise a blend of 33.6 wt% Sph BN (PTX60 from General Electric Company), 66.4wt% of a 1:1 blend of polyoctadecylmethylsiloxane (source: Gelest, with visc @50C = 250-300, Lot#4F-5043, prod# ALT-192) and SF96 ((from GE Silicones of Waterford, NY, as SF96-1000, viscosity = 1000cp). The sample is blended by first heating the SF96 & ALT-192 in a plastic container at 110°C. To the hot mixture, the spherical BN agglomerate filler is added. The mix is stirred by hand mixing for 2 minutes to give a smooth blend. The mixture is allowed to cool and thus solidified prior to testing. The samples are assembled at 60°C and under 206.84 kPa (30 psi) load, between A1-A1 coupons.

Examples labeled PCMs 56-01 comprises a blend of 33.8 wt% sph BN (PTX60 from General Electric Company) in 66.2wt% of polyoctadecylmethylsiloxane (from Gelest, vise @50C = 250-300). The samples are made as described above.

Table 9 presents test results obtained from samples under 4 different conditions. In the test, the resistance is measured by using bolts and a torque wrench to apply a specific torque that translates to a particular pressure kPa (psi). The samples are measured at 25°C, under no load; 25°C, with 206.84 kPa (30 psi) load; 100°C, with the same clamping force; 100 °C, retorquing to 206.84 kPa (30 psi). It is noted that when the phase change occurs, the viscosity reduces and the BLT reduces, thus relieving the pressure applied by the bolts. If the pressure is applied using a spring force, the 206.84 kPa (30 psi) pressure would still be maintained even if the BLT reduced. Hence, after measuring at 100°C, the samples are retorqued to 206.84 kPa (30 psi) and measured.

The 30psi retorqued example is illustrative of applications wherein a spring clip is used.

**Table 9:**

| Sample # | Pressure / kPa (psi) | Temperature / °C | BLT / µm (mils) | Tc /W/mK | TR / mm²K/W |
|---|---|---|---|---|---|
| 55-2 | 0 psi | 25 | 79.5(3.13) | 0.91 | 88.61 |
| 55-2 | 206.84 (30) | 25 | 79 (3.11) | 1.60 | 49.70 |
| 55-2 | 206.84 (30) | 100 | 64.77 (2.55) | 2.56 | 25.49 |
| 55-2 | 206.84(30) retorqued | 100 | 46.48 (1.83) | 4.88 | 9.55 |
| 56-1 | 0 psi | 25 | 62.99 (2.48) | 1.33 | 47.78 |
| 56-1 | 206.84(30) | 25 | 64.26 (2.53) | 1.84 | 37.16 |
| 56-1 | 206.84 (30) | 100 | 60.71 (2.39) | 2.82 | 22.31 |
| 56-1 | 206.84 (30) retorqued | 100 | 39.62 (1.56) | 5.50 | 7.22 |

## Claims

1. A thermally conductive composition comprising a blend of a polymer matrix and spherical boron nitride agglomerates as a filler, wherein the spherical boron nitride agglomerates are formed of irregular non-spherical BN particles bound together by a binder and subsequently spray-dried, and having an average aspect ratio of less than 2 and wherein the agglomerates are coated with at least one of a metal powder, a metal alloy powder, a fatty acid partial ester of sorbitan anhydride, a titanate, a zirconate, a benzoic acid derivative, an acytoxy silane, an alkoxy silane, a methoxy silane, a sorbitan monostearate, a sorbitan monolaurate, a sorbitan monoleate, a sorbitan monopalmate, a polyoxyethylene sorbitan monolaurate, a polyoxyethylene sorbitan monostearate, a polyoxyethylene sorbitan monooleate, a polyoxyethylene sorbitan monopalmate, a silazane, a silanol, a silane compound, a siloxane compound, a polymer containing alkoxy, hydroxy or Si-H group, a titanate, a zirconate, a benzoic acid derivative, and mixtures thereof.

2. The thermally conductive composition of claim 1 , wherein the spherical boron nitride filler is present in an amount of about 5 to 80 wt. % of the total weight of the thermally conductive composition.

3. The thermally conductive composition of any of the preceding claims, wherein the spherical boron nitride filler has an average agglomerate particle size of 10 to 200 microns.

4. The thermally conductive composition of any of the preceding claims, wherein at least 60 wt. % of the spherical boron nitride filler has an average agglomerate size within a particle size distribution of 40 to 200 microns.

5. The thermally conductive composition of any of the preceding claims, wherein the spherical boron nitride has average aspect ratio of less than 1.5.

6. A thermally conductive composition of any of the preceding claims, wherein the thermally conductive composition possesses a bond line thickness of less than 1270 µm (50 mils).

7. The thermally conductive composition of any of the preceding claims, wherein the thermally conductive composition possesses a bond line thickness of from about 0.51 µm (0.02 mil) to about 81.28 µm (3.2 mil).

8. The thermally conductive composition of any of any of the preceding claims, which is formed into a film, a pad, a sheet, a gel or a paste or a grease.

9. The thermally conductive composition of any of the preceding claims, wherein the polymer matrix comprises a polymeric composition selected from the group of an α-olefin based polymer, an ethylene / α-olefin copolymer, an ethylene / α-olefin / non-conjugated polyene random copolymer, a polyol-ester, and an organosiloxane.

10. The thermally conductive composition of any of the preceding claims, wherein the organosiloxane is selected from the group of a polydimethylsiloxane, a polyalkylsiloxane, a polydimethyl-co-methylphenylsiloxane, a polydimethyl-co- diphenylsiloxane, and an organo-functionalized polydimethylsiloxane.

11. The thermally conductive composition of any of the preceding claims, wherein the polymer matrix comprises a curable composition selected from the group consisting of polydimethylsiloxanes, epoxies, acrylates, organopolysiloxane, polyimide, fluorocarbons, benzocyclobutene, fluorinated polyallyl ether, polyamide, polyimidoamide, cyanate esters, phenolic resin, aromatic polyester, poly arylene ether, bismaleimide, fluororesins, and combinations thereof.

12. The thermally conductive composition of any of the preceding claims, further comprising a catalyst inhibitor.

13. The thermally conductive composition of any of the preceding claims, further comprising an adhesion promoter selected from the group consisting of alkoxysilanes, aryloxysilanes, silanols, oligosiloxanes containing an alkoxy silyl functional group, oligosiloxanes containing an aryloxysilyl functional group, oligosiloxanes containing a hydroxyl functional group, polysiloxanes containing an alkoxy silyl functional group, polysiloxanes containing an aryloxysilyl functional group, polysiloxanes containing a hydroxyl functional group, cyclosiloxanes containing an alkoxy silyl functional group, cyclosiloxanes containing an aryloxysilyl functional group, cyclosiloxanes containing a hydroxyl functional group, titanates, trialkoxy aluminum, tetraalkoxysilanes, isocyan urates, and mixtures thereof.

14. A method of increasing heat transfer comprising:
positioning a heat producing component in contact with a thermally conductive composition according to claim 1.

15. A thermally conductive composition according to claim 1 comprising a blend of a matrix comprising a material which is liquid at room temperature, a metal or metal alloy which has a melting point of less than 35°C, and spherical boron nitride as a filler, wherein the spherical boron nitride is formed of irregular non-spherical BN particles bound together by a binder and subsequently spray-dried, and having an average aspect ratio of less than 2.

16. The thermally conductive composition according to claim 1 **characterized in that** the agglomerates have a fracture strength to envelope density ratio greater than about 6.5 MPa.cc/g.

17. The thermally conductive composition according to claim 1 **characterized in that** the average agglomerate size is of 20 to about 1000 microns.

18. Use of the thermally conductive composition according to one of claims 1 to 13 and 15 to 17 in electronic applications.

## Patentansprüche

1. Wärmeleitfähige Zusammensetzung, umfassend eine Mischung aus einer Polymermatrix und kugelförmigen Bornitridagglomeraten als Füllstoff, wobei die kugelförmigen Bornitridagglomerate aus unregelmäßigen, nicht kugelförmigen BN-Partikeln bestehen, die durch ein Bindemittel aneinander gebunden und anschließend sprühgetrocknet wurden und ein mittleres Seitenverhältnis von unter 2 haben, und wobei die Agglomerate beschichtet sind mit mindestens einem aus einem Metallpulver, einem Metalllegierungspulver, einem Sorbitananhydrid-Fettsäurepartialester, einem Titanat, einem Zirkonat, einem Benzoesäurederivat, einem Acytoxysilan, einem Alkoxysilan, einem Methoxysilan, einem Sorbitanmonostearat, einem Sorbitanmonolaurat, einem Sorbitanmonoleat, einem Sorbitanmonopalmat, einem Polyoxyethylensorbitanmonolaurat, einem Polyoxyethylensorbitanmonostearat, eine Polyoxyethylensorbitanmonoleat, einem Polyoxyethylensorbitanmonopalmat, einem Silazan, einem Silanol, einer Silanverbindung, einer Siloxanverbindung, einem eine Alkoxy-, Hydroxy- oder Si-H-Gruppe, ein Titanat-, ein Zirkonat-, ein Benzoesäurederivat-enthaltendes Polymer und/oder Gemischen von diesen.

2. Wärmeleitfähige Zusammensetzung nach Anspruch 1, wobei der kugelförmige Bornitridfüllstoff in einer Menge von ca. 5 bis 80 Gew.-% des Gesamtgewichts der wärmeleitfähigen Zusammensetzung vorhanden ist.

3. Wärmeleitfähige Zusammensetzung nach einem der vorhergehenden Ansprüche, wobei der kugelförmige Bornitridfüllstoff eine mittlere Agglomeratpartikelgröße von 10 bis 200 Mikron hat.

4. Wärmeleitfähige Zusammensetzung nach einem der vorhergehenden Ansprüche, wobei mindestens 60 Gew.-% des kugelförmigen Bornitridfüllstoffs eine mittlere Agglomeratgröße innerhalb einer Partikelgrößenverteilung von 40 bis 200 Mikron haben.

5. Wärmeleitfähige Zusammensetzung nach einem der vorhergehenden Ansprüche, wobei das kugelförmige Bornitrid ein mittleres Seitenverhältnis von unter 1,5 hat.

6. Wärmeleitfähige Zusammensetzung nach einem der vorhergehenden Ansprüche, wobei die wärmeleitfähige Zusammensetzung eine Klebschichtdicke von unter 1270 µm (50 Tausendstel Zoll) besitzt.

7. Wärmeleitfähige Zusammensetzung nach einem der vorhergehenden Ansprüche, wobei die wärmeleitfähige Zusammensetzung eine Klebschichtdicke von ca. 0,51 µm (0,02 Tausendstel Zoll) bis ca. 81,28 µm (3,2 Tausendstel Zoll) besitzt.

8. Wärmeleitfähige Zusammensetzung nach einem der vorhergehenden Ansprüche, die zu einem Film, einem Pad, einem Flächenkörper, einem Gel oder einer Paste oder einem Fett geformt ist.

9. Wärmeleitfähige Zusammensetzung nach einem der vorhergehenden Ansprüche, wobei die Polymermatrix eine Polymerzusammensetzung umfasst, die aus der Gruppe eines auf α-Olefin basierten Polymers, eines Ethylen/α-Olefin Copolymers, eines Zufallscopolymers aus Ethylen/α-Olefin/nicht konjugiertem Polyen, eines Polyolesters und eines Organosiloxans ausgewählt ist.

10. Wärmeleitfähige Zusammensetzung nach einem der vorhergehenden Ansprüche, wobei das Organosiloxan aus der Gruppe eines Polydimethylsiloxans, eines Polyalkylsiloxans, eines Polydimethyl-co-methylphenylsiloxans, eines Polydimethyl-co-diphenylsiloxans und eines organo-funktionalisierten Polydimethylsiloxans ausgewählt ist.

11. Wärmeleitfähige Zusammensetzung nach einem der vorhergehenden Ansprüche, wobei die Polymermatrix eine vernetzbare Zusammensetzung umfasst, die aus der Gruppe ausgewählt ist, die aus Polydimethylsiloxanen, Epoxiden, Acrylaten, Organopolysiloxan, Polyimid, Fluorkohlenstoffen, Benzocyclobuten, fluoriertem Polyallylether, Polyamid, Polyimidamid, Cyanatestern, Phenolharz, aromatischem Polyester, Polyarylenether, Bismaleimid, Fluorharzen und Kombinationen von diesen besteht.

12. Wärmeleitfähige Zusammensetzung nach einem der vorhergehenden Ansprüche, darüber hinaus einen Katalysatorhemmstoff umfassend.

13. Wärmeleitfähige Zusammensetzung nach einem der vorhergehenden Ansprüche, darüber hinaus einen Haftvermittler umfassend, der aus der Gruppe ausgewählt ist, die aus Alkoxysilanen, Aryloxysilanen, Silanolen, Oligosiloxanen, die eine Alkoxysilylfunktionsgruppe enthalten, Oligosiloxanen, die eine Aryloxysilylfunktionsgruppe enthalten, Oligosiloxanen, die eine Hydroxylfunktionsgruppe enthalten, Polysiloxanen, die eine Alkoxysilylfunktionsgruppe enthalten, Polysiloxanen, die eine Aryloxysilylfunktionsgruppe enthalten, Polysiloxanen, die eine Hydroxylfunktionsgruppe enthalten, Cyclosiloxanen, die eine Alkoxysilylfunktionsgruppe enthalten, Cyclosiloxanen, die eine Aryloxysilylfunktionsgruppe enthalten, Cyclosiloxanen, die eine Hydroxylfunktionsgruppe enthalten, Titanaten, Trialkoxyaluminium, Tetraalkoxysilanen, Isocyanuraten und Gemischen von diesen besteht.

14. Verfahren zum Verstärken eines Wärmeaustauschs, umfassend:
Anordnen eines Wärme erzeugenden Bauteils in Kontakt mit einer wärmeleitfähigen Zusammensetzung nach Anspruch 1.

15. Wärmeleitfähige Zusammensetzung nach Anspruch 1, eine Mischung aus einer Matrix, die ein Material umfasst, das bei Raumtemperatur flüssig ist, einem Metall oder einer Metalllegierung, das bzw. die eine Schmelztemperatur von unter 35°C hat, und kugelförmigem Bornitrid als Füllstoff umfassend, wobei das kugelförmige Bornitrid aus unregelmäßigen nicht kugelförmigen BN-Partikeln besteht, die durch ein Bindemittel aneinander gebunden und anschließend sprühgetrocknet wurden und ein mittleres Seitenverhältnis von unter 2 haben.

16. Wärmeleitfähige Zusammensetzung nach Anspruch 1, **dadurch gekennzeichnet, dass** die Agglomerate ein Verhältnis Bruchfestigkeit zu Hüllendichte von über ca. 6,5 MPa.cc/g haben.

17. Wärmeleitfähige Zusammensetzung nach Anspruch 1, **dadurch gekennzeichnet, dass** die mittlere Agglomeratgröße von 20 bis ca. 1000 Mikron beträgt.

18. Verwendung der wärmeleitfähigen Zusammensetzung nach einem der Ansprüche 1 bis 13 und 15 bis 17 in elektronischen Anwendungen.

## Revendications

1. Composition thermoconductrice comprenant un mélange d'une matrice polymère et d'agglomérats de nitrure de bore sphérique en tant qu'agent de charge, sachant que les agglomérats de nitrure de bore sphérique sont formés de particules de NB non sphérique irrégulières liées ensemble par un lieur et subséquemment séchées par pulvérisation, et ayant un rapport d'aspect moyen inférieur à 2 et sachant que les agglomérats sont revêtus d'au moins l'un d'une poudre métallique, d'une poudre d'alliage de métal, d'un ester partiel d'acide gras d'anhydride de sorbitan, d'un titanate, d'un zirconate, d'un dérivé d'acide benzoïque, d'un acytoxysilane, d'un alcoxysilane, d'un méthoxysilane, d'un monostéarate de sorbitan, d'un monolaurate de sorbitan, d'un monoléate de sorbitan, d'un monopalmate de sorbitan, d'un monolaurate de sorbitan de polyoxyéthylène, d'un monostéarate de sorbitan de polyoxyéthylène, d'un monooléate de sorbitan de polyoxyéthylène, d'un monopalmate de sorbitan de polyoxyéthylène, d'un silazane, d'un silanol, d'un composé de silane, d'un composé de siloxane, d'un polymère contenant un groupe alcoxy, un groupe hydroxy ou de Si-H, un titanate, un zirconate, un dérivé d'acide benzoïque, et de mélanges de ceux-ci.

2. La composition thermoconductrice de la revendication 1, dans laquelle l'agent de charge à nitrure de bore sphérique est présent dans une quantité d'environ 5 à 80 % en poids du poids total de la composition thermoconductrice.

3. La composition thermoconductrice de l'une quelconque des revendications précédentes, dans laquelle l'agent de charge à nitrure de bore sphérique a une taille de particule d'agglomérat moyenne de 10 à 200 microns.

4. La composition thermoconductrice de l'une quelconque des revendications précédentes, dans laquelle au moins 60 % en poids de l'agent de charge à nitrure de bore sphérique a une taille d'agglomérat moyenne comprise dans une distribution de taille de particule de 40 à 200 microns.

5. La composition thermoconductrice de l'une quelconque des revendications précédentes, dans laquelle le nitrure de bore sphérique a un rapport d'aspect moyen inférieur à 1,5.

6. Composition thermoconductrice de l'une quelconque des revendications précédentes, dans laquelle la composition thermoconductrice présente une épaisseur de ligne de jonction inférieure à 1 270 µm (50 millièmes de pouce).

7. La composition thermoconductrice de l'une quelconque des revendications précédentes, dans laquelle la composition thermoconductrice présente une épaisseur de ligne de jonction allant d'environ 0,51 µm (0,02 millièmes de pouce) à environ 81,28 µm (3,2 millièmes de pouce).

8. La composition thermoconductrice de l'une quelconque des revendications précédentes, laquelle est mise en forme de film, de tampon, de feuille, de gel ou de pâte ou de graisse.

9. La composition thermoconductrice de l'une quelconque des revendications précédentes, dans laquelle la matrice polymère comprend une composition polymère sélectionnée dans le groupe constitué par un polymère à base d'α-oléfine, un copolymère d'éthylène / d'α-oléfine, un copolymère aléatoire d'éthylène / d'α-oléfine / de polyène non conjugué, un polyol-ester, et un organosiloxane.

10. La composition thermoconductrice de l'une quelconque des revendications précédentes, dans laquelle l'organosiloxane est sélectionné dans le groupe constitué par un polydiméthylsiloxane, un polyalkylsiloxane, un polydiméthyl-co-méthylphénylsiloxane, un polydiméthyl-co-diphénylsiloxane, et un polydiméthylsiloxane organo-fonctionnalisé.

11. La composition thermoconductrice de l'une quelconque des revendications précédentes, dans laquelle la matrice polymère comprend une composition durcissable sélectionnée dans le groupe constitué par les polydiméthylsiloxanes, les époxys, les acrylates, l'organopolysiloxane, le polyimide, les fluorocarbones, le benzocyclobutène, l'éther polyallylique fluoré, le polyamide, le polyimidoamide, les esters de cyanate, la résine phénolique, le polyester aromatique, l'éther de polyarylène, le bismaleimide, les fluororésines, et les combinaisons de ceux-ci.

12. La composition thermoconductrice de l'une quelconque des revendications précédentes, comprenant en outre un inhibiteur de catalyse.

13. La composition thermoconductrice de l'une quelconque des revendications précédentes, comprenant en outre un promoteur d'adhésion sélectionné dans le groupe constitué par les alcoxysilanes, les aryloxysilanes, les silanols, les oligosiloxanes contenant un groupe fonctionnel d'alcoxysilyle, les oligosiloxanes contenant un groupe fonctionnel d'aryloxysilyle, les oligosiloxanes contenant un groupe fonctionnel d'hydroxyle, les polysiloxanes contenant un groupe fonctionnel d'alcoxysilyle, les polysiloxanes contenant un groupe fonctionnel d'aryloxysilyle, les polysiloxanes contenant un groupe fonctionnel d'hydroxyle, les cyclosiloxanes contenant un groupe fonctionnel d'alcoxysilyle, les cyclosiloxanes contenant un groupe fonctionnel d'aryloxysilyle, les cyclosiloxanes contenant un groupe fonctionnel d'hydroxyle, les titanates, l'aluminium de trialcoxy, les tétraalcoxysilanes, les urates d'isocyane, et les mélanges de ceux-ci.

14. Procédé d'augmentation de transfert thermique comprenant :
le positionnement d'un composant producteur de chaleur en contact avec une composition thermoconductrice selon la revendication 1.

15. Composition thermoconductrice selon la revendication 1, comprenant un mélange d'une matrice comprenant un matériau qui est liquide à température ambiante, un métal ou un alliage de métal qui a un point de fusion inférieur à 35°C, et du nitrure de bore sphérique comme agent de charge, sachant que le nitrure de bore sphérique est formé de particules de NB non sphérique irrégulières liées ensemble par un lieur et subséquemment séchées par pulvérisation, et ayant un rapport d'aspect moyen inférieur à 2.

16. La composition thermoconductrice selon la revendication 1, **caractérisée en ce que** les agglomérats ont un rapport de résistance à la rupture à la densité d'enveloppe supérieur à environ 6,5 MPa.cc/g.

17. La composition thermoconductrice selon la revendication 1, **caractérisée en ce que** la taille d'agglomérat moyen est de 20 à environ 1 000 microns.

18. Utilisation de la composition thermoconductrice selon l'une des revendications 1 à 13 et 15 à 17 dans des applications électroniques.
